(19) Europäisches Patentamt / European Patent Office / Office européen des brevets

(11) **EP 4 343 390 A1**

(12) **EUROPEAN PATENT APPLICATION**
published in accordance with Art. 153(4) EPC

(43) Date of publication:
**27.03.2024 Bulletin 2024/13**

(21) Application number: **22820029.1**

(22) Date of filing: **23.05.2022**

(51) International Patent Classification (IPC):
**G02B 5/02** (2006.01)    **B32B 7/023** (2019.01)
**G02B 1/115** (2015.01)    **G02B 1/14** (2015.01)
**G02B 1/18** (2015.01)    **G02B 5/30** (2006.01)
**G02F 1/1335** (2006.01)    **G09F 9/00** (2006.01)
**G09F 9/30** (2006.01)    **H01L 27/32** (2006.01)
**H01L 51/50** (2006.01)    **H05B 33/02** (2006.01)

(52) Cooperative Patent Classification (CPC):
**B32B 7/023; G02B 1/115; G02B 1/14; G02B 1/18; G02B 5/02; G02B 5/30; G02F 1/1335; G09F 9/00; G09F 9/30; H05B 33/02; H10K 50/00; H10K 59/00**

(86) International application number:
**PCT/JP2022/021072**

(87) International publication number:
**WO 2022/259847 (15.12.2022 Gazette 2022/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.06.2021 JP 2021096144**
**12.05.2022 JP 2022078782**

(71) Applicant: **Dexerials Corporation**
**Shimotsuke-shi, Tochigi 323-0194 (JP)**

(72) Inventors:
• **SUGATA, Hiroshi**
 **Shimotsuke-shi, Tochigi 323-0194 (JP)**
• **ONO, Tetsuya**
 **Shimotsuke-shi, Tochigi 323-0194 (JP)**
• **OTA, Takaaki**
 **Shimotsuke-shi, Tochigi 323-0194 (JP)**

(74) Representative: **Müller-Boré & Partner**
**Patentanwälte PartG mbB**
**Friedenheimer Brücke 21**
**80639 München (DE)**

(54) **OPTICAL LAMINATE, POLARIZING PLATE, IMAGE DISPLAY DEVICE, AND METHOD FOR MANUFACTURING OPTICAL LAMINATE**

(57)    [Problem]To improve abrasion resistance while maintaining an anti-glare property. [Solution] An optical laminate 10 is provided with a transparent substrate 11, at least one or more hard coat layers 12 that are provided on the transparent substrate 11 and are made of a resin composition, and at least one or more metal-oxide layers (adhesion layer 13, antireflection layer 14) that are provided on the hard coat layer 12 and are made of a metal oxide. A concave/convex structure is formed on the metal-oxide layer side surface of the hard coat layer 12, and the height distribution of the surface of the concave/convex structure satisfies the following formula (1). (1): $A/1.9 < P$ where A is the height of the highest point on the surface of the concave/convex structure when the height B of the lowest point on the surface of the concave/convex structure is defined as 0, and P is the mode of the height distribution of the surface of the concave/convex structure when the height B of the lowest point on the surface of the concave/convex structure is defined as 0.

FIG.1

**EP 4 343 390 A1**

**Description**

**TECHNICAL FIELD**

The present invention relates to an optical laminate, a polarizer, an image display device, and a method for manufacturing the optical laminate.

**BACKGROUND TECHNOLOGY**

An antireflection film is a transparent film having antireflection properties. Conventionally, an optical laminate provided with a multilayer film in which a high refractive index layer and a low refractive index layer are sequentially laminated on a transparent substrate is used as an antireflection film. The antireflection film is provided on a display screen of a display device such as a liquid crystal display (LCD), a plasma display (PDP), or an organic EL display (OELD). Thus, the reflectance of the display screen can be reduced by using the principle of optical interference, and reduction in contrast and reflection of an image due to reflection of external light on the display screen can be suppressed.

Furthermore, as an antireflection film, a AGAR type film having anti-glare properties (anti-glare: AG) as well as antireflection properties (antireflection: AR) has also been developed. In order to impart anti-glare properties to an antireflection film, a technique has been proposed in which a rough surface structure is formed on a film surface using micro-order fine particles (fillers) and incident light is scattered by the rough surface structure.

For example, in Patent Document 1, a technique is disclosed that, by dispersing and containing mat particles of 1 to 10 $\mu$m in an anti-glare hard-coat layer that is a high refractive index layer, forms a protruding structure having a dome-shaped protrusion according to a particle shape of the mat particles on a surface of an antireflection film to impart anti-glare properties to the antireflective film. Furthermore, Patent Document 2 discloses a technique for forming a protruding structure having a dome-shaped protrusion on a film surface by including translucent fine particles having a diameter of 2 to 5 $\mu$m or an inorganic filler in an anti-glare layer.

**CITATION LIST**

**PATENT DOCUMENTS**

Patent Document 1: Japanese Patent No. 5331919
Patent Document 2: Japanese Patent No. 4431540

**SUMMARY OF INVENTION**

**PROBLEM TO BE SOLVED BY INVENTION**

However, there is a problem that abrasion resistance of the antireflective film decreases when a protruding structure is formed on the surface of the antireflective film as described in patent documents 1 and 2 in order to impart anti-glare properties to the antireflection film. For example, when an antireflection film is provided on a display screen such as a touch panel of a smart phone or various operating devices, a load applied to the surface screen by a finger or a pointing device of an operator concentrates on a protrusion portion of the protruding structure. Thus, there is a problem that the protruding structure is scraped and easily damaged, and the abrasion resistance of the film surface decreases. Therefore, conventionally, there has been a desire for an optical laminate that can improve abrasion resistance of the film surface while maintaining anti-glare properties by eliminating the protruding structure as much as possible and forming a recessed rough surface structure on the surface of the antireflection film.

Therefore, in light of the above problems, an object of the present invention is to provide an optical laminate that can improve abrasion resistance while maintaining anti-glare properties, and to provide a polarizer and image display device provided with this, and a method for manufacturing the optical laminate.

**MEANS TO SOLVE THE PROBLEM**

In order to solve the above problems, according to one aspect of the present invention, an optical laminate is provided, comprising:

a transparent substrate;

at least one or more hard-coat layers that are provided on the transparent substrate and are made of a resin composition; and

at least one or more metal-oxide layers that are provided on the hard-coat layer and are made of a metal oxide; wherein a concave/convex structure is formed on the metal-oxide-layer-side surface of the hard-coat layer, and

the height distribution of the surface of the concave/convex structure satisfies the following formula (1).

$$A/1.9<P \quad (1)$$

A: The height of the highest point on the surface of the concave/convex structure when the height B of the lowest point on the surface of the concave/convex structure is defined as 0;

P: The mode of the height distribution of the surface of the concave/convex structure when the height B of the lowest point on the surface of the concave/convex structure is defined as 0

The tops of the plurality of convex portions constituting the concave/convex structure of the hard-coat layer may have substantially the same heights as each other.

The outermost surface of the optical laminate may be made to be an uneven surface conforming to the shape of the concave/convex structure of the hard-coat layer, and

the tops of the plurality of convex portions constituting the uneven surface may have substantially the same heights as each other.

The tops of the plurality of convex portions constituting the concave/convex structure of the hard-coat layer may each have substantially flat faces.

The outermost surface of the optical laminate may be made to be an uneven surface conforming to the shape of the concave/convex structure of the hard-coat layer, and

the tops of the plurality of convex portions constituting the uneven surface may each have substantially flat faces.

The surface roughness Sa of the concave/convex structure of the hard-coat layer may be 50 to 300 nm.

The contact angle relative to water of the outermost surface of the optical laminate upon using a rubbing tester using steel wool to rub the steel wool against the surface of the optical laminate under conditions of a load of 1 kg, a contact area of 1 cm $\times$ 1 cm, and 2,000 reciprocations may be 90 degrees or greater.

An external haze value defined by JIS K7136 may be 3 to 40%.

The hard-coat layer may include metal-oxide fine particles having an average particle size of 20 to 100 nm.

The hard-coat layer does not need to contain filler particles having an average particle size of 1 $\mu$m or more.

The metal-oxide layer may include an antireflective layer,

the antireflective layer may be made of a laminate in which a low refractive index layer and a high refractive index layer having a refractive index greater than that of the low refractive index layer are alternatingly laminated, and

the optical laminate may be an antireflective film having an anti-glare function and an antireflection function.

The metal-oxide layer may include an adhesive layer provided between the hard-coat layer and the antireflective layer.

In order to solve the above problem, according to another aspect of the present invention,

a polarizer including the optical laminate is provided.

In order to solve the above problem, according to another aspect of the present invention,

an image display device including the optical laminate is provided.

In order to solve the above problem, according to another aspect of the present invention,

a method for manufacturing the optical laminate is provided, the method comprising:

a step of providing the hard-coat layer made of a resin composition on the transparent substrate;

a step of providing the at least one or more metal-oxide layers on the hard-coat layer; and

a step of providing an antifouling layer on the metal-oxide layer; wherein

the step of providing the hard-coat layer has

a step of coating the resin composition on the surface of the transparent substrate and

a step of transferring a concave/convex shape of a transfer mold into the resin composition.

## EFFECT OF THE INVENTION

According to the present invention, it is possible to improve abrasion resistance while maintaining anti-glare properties.

**BRIEF DESCRIPTION OF THE DRAWINGS**

[FIG. 1] FIG. 1 is a cross-sectional view illustrating an optical laminate of one embodiment of the present invention.
[FIG. 2] FIG. 2 is a cross-sectional view illustrating an example of a hard-coat layer according to the same embodiment.
[FIG. 3] FIG. 3 is a diagram illustrating a 3D image of an example of an optical laminate of the same embodiment.
[FIG. 4] FIG. 4 is a diagram illustrating a cross-sectional roughness of an example of the optical laminate of the same embodiment.
[FIG. 5] FIG. 5 is a flowchart illustrating a method for manufacturing the optical laminate of the same embodiment.
[FIG. 6] FIG. 6 is a process diagram describing an example of a method for manufacturing a transfer mold of the same embodiment.
[FIG. 7] FIG. 7 is a process diagram describing a coating step and a transfer step of the same embodiment.
[FIG. 8] FIG. 8 is a diagram illustrating a histogram of a sample A of a comparative example.
[FIG. 9] FIG. 9 is a diagram illustrating a histogram of a sample B of a comparative example.
[FIG. 10] FIG. 10 is a diagram illustrating a histogram of a sample C of a comparative example.
[FIG. 11] FIG. 11 is a diagram illustrating a histogram of a sample D of a comparative example.
[FIG. 12] FIG. 12 is a diagram illustrating a histogram of a sample E of a comparative example.
[FIG. 13] FIG. 13 is a diagram illustrating a histogram of a sample K of a comparative example.
[FIG. 14] FIG. 14 is a diagram illustrating a histogram of a sample F of an example.
[FIG. 15] FIG. 15 is a diagram illustrating a histogram of a sample G of an example.
[FIG. 16] FIG. 16 is a diagram illustrating a histogram of a sample H of an example.
[FIG. 17] FIG. 17 is a diagram illustrating a histogram of a sample I of an example.
[FIG. 18] FIG. 18 is a diagram illustrating a histogram of a sample J of an example.

**DESCRIPTION OF THE EMBODIMENTS**

Embodiments of the present invention will be described in detail below with reference to attached drawings. The dimensions, materials, and other specific numerical values and the like illustrated in such embodiments are only examples for facilitating understanding of the invention, and the present invention is not limited thereto, except as otherwise specifically noted. Note that in the present specification and the drawings, overlapping descriptions are omitted for elements having substantially the same functions and configurations by attaching the same reference numerals, and elements not directly related to the present invention are omitted from the drawings.
Note that in each of the drawings referred to in the description below, for the convenience in describing, there are cases in which the size of a portion of the constituent elements may be exaggerated. Therefore, the relative sizes of the constituent elements illustrated in each drawing do not necessarily accurately express the size relationships between the actual constituent elements.

[1. Overall Configuration of Optical Laminate]

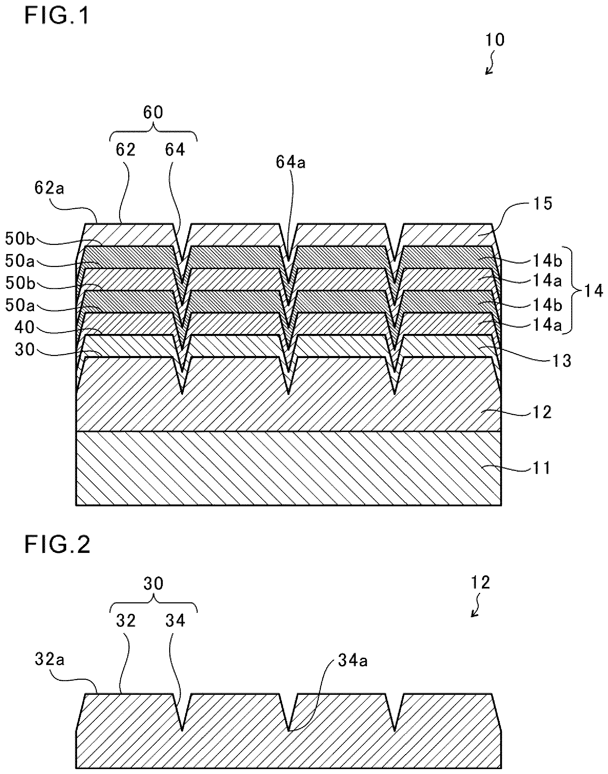

First, an overall configuration of an optical laminate 10 of the fist embodiment of the present invention will be described with reference to FIG. 1. FIG. 1 is a cross-sectional view illustrating the optical laminate 10 of the present embodiment.
The optical laminate 10 of the present embodiment is used, for example, as a AGAR type antireflection film having an anti-glare function (anti-glare: AG) and an antireflection function (antireflection: AR). As illustrated in FIG. 1, the optical laminate 10 of the present embodiment is configured by laminating a transparent substrate 11, a hard-coat layer 12, an adhesive layer 13, an antireflective layer 14, and an antifouling layer 15 in this order. Each layer is described below.

[Transparent Substrate 11]

The transparent substrate 11 is formed by, for example, a transparent material which is capable of transmitting light in the visible light region having a wavelength of 350 to 830 nm. Note that in the present embodiment, the "transparent material" is a material that does not impair the effect of the optical laminate 10 of the present embodiment, having a light transmittance of, for example, 80% or more in the used wavelength region within a range.
The transparent substrate 11 may be composed of, for example, a plastic film as an organic material or a glass film as an inorganic material. The constituent materials of the plastic film are one or a plurality among a polyester resin, an acetate resin, a polyethersulfone resin, a polycarbonate resin, a polyamide resin, a polyimide resin, a polyolefin resin, a (meth)acrylic resin, a polyvinyl chloride resin, a polyvinylidene chloride resin, a polystyrene resin, a polyvinyl alcohol resin, a polyarylate resin, and a polyphenylene sulfide resin, preferably, one or a plurality among a polyester resin, an acetate resin, a polycarbonate resin, and a polyolefin resin. Note that in the present embodiment, "(meth)acrylic" signifies methacrylic and acrylic.

The transparent substrate 11 is composed of, for example, one or a plurality selected from the group of polycarbonate (PC), polyethylene terephthalate (PET), triacetyl cellulose (TAC), polyimide (PI), polymethyl methacrylate (PMMA), cycloolefin polymer (COP), cycloolefin copolymer (COC) and glass.

In the present embodiment, an example will be described in which the transparent substrate 11 is configured from triacetyl cellulose (TAC). When the transparent substrate 11 is composed of TAC, when the hard-coat layer 12 is formed on one surface side thereof, an penetration layer is formed by penetrating a part of components constituting the hard-coat layer 12. As a result, adhesion between the transparent substrate 11 and the hard-coat layer 12 is improved, and generation of interference fringes due to a mutual difference in refractive index between the layers can be suppressed.

Furthermore, the transparent substrate 11 may include a reinforcing material so long as the optical properties are not significantly impaired. The reinforcing material is, for example, cellulose nanofiber, nanosilica, or the like.

Furthermore, the transparent substrate 11 may be a film to which one or both of an optical function and a physical function are imparted. As examples of a film having one or both of an optical function and a physical function, a polarizer, a phase difference compensation film, a heat ray shielding film, a transparent conductive film, a brightness improving film, a barrier property improving film, and the like are included.

The thickness of the transparent substrate 11 is not particularly limited, but from the perspective of handling properties, flexibility, cost, and characteristics, it is, for example, 10 to 500 $\mu$m, preferably 25 to 188 $\mu$m, and more preferably 40 to 100 $\mu$m.

When the thickness of the transparent substrate 11 is 25 $\mu$m or more, the rigidity of the substrate itself is secured, and wrinkles are less likely to occur even if stress is applied to the optical laminate 10. Furthermore, when the thickness of the transparent substrate 11 is 25 $\mu$m or more, wrinkles are less likely to occur and manufacturing concerns are minimal even if the hard-coat layer 12 is continuously formed on the transparent substrate 11, which is preferable. When the thickness of the transparent substrate 11 is 40 $\mu$m or more, wrinkles are yet more unlikely to occur, which is preferable.

When a roll is used during the manufacture of the optical laminate 10, the thickness of the transparent substrate 11 is preferably 1,000 $\mu$m or less, and more preferably 600 $\mu$m or less. When the thickness of the transparent substrate 11 is 1,000 $\mu$m or less, the optical laminate 10 during manufacture and the optical laminate 10 after manufacturing can be easily wound into a roll shape, and thus the optical laminate 10 can be efficiently manufactured. Furthermore, when the thickness of the transparent substrate 11 is 1,000 $\mu$m or less, the optical laminate 10 can be reduced in thickness and weight. When the thickness of the transparent substrate 11 is 600 $\mu$m or less, the optical laminate 10 can be more efficiently manufactured, and the thickness and weight can be further reduced, which is preferable.

The transparent substrate 11 may be subjected in advance to one or a plurality of processes from among various processes such as sputtering, corona discharge, ultraviolet irradiation, electron beam irradiation, chemical conversion, etching processes such as oxidation, undercoating processes, and the like. The adhesion between the hard-coat layer 12 formed on the transparent substrate 11 and the transparent substrate 11 can be improved by applying these processes to the surface of the transparent substrate 11 in advance. Furthermore, it is also preferable that the surface of the transparent substrate 11 is cleared of dust and cleaned by performing solvent cleaning, ultrasonic cleaning, or the like on the surface of the transparent substrate 11 as needed before the hard-coat layer 12 is formed on the transparent substrate 11.

[Hard-Coat Layer 12]

The hard-coat layer 12 is provided on the transparent substrate 11. The hard-coat layer 12 is an AG type hard-coat layer, and a concave/convex structure 30 for imparting an anti-glare properties to the optical laminate 10 is formed on the surface of the hard-coat layer 12. The hard-coat layer 12 is composed of a resin, for example, a cured product of a resin composition. The resin that composes the hard-coat layer 12 is not particularly limited, and examples include energy ray-curable resins such as ultraviolet ray-curable resins, electron beam-curable resins, infrared ray-curable resins, and the like, as well as thermosetting resins, thermoplastic resins, two-component mixing resins, and the like. Among these, it is preferable to use an ultraviolet ray-curable resin that can efficiently form the hard-coat layer 12 by ultraviolet irradiation.

Examples of the ultraviolet ray-curable resin include acrylic resins, urethane resins, epoxy resins, polyester resins, amide resins, silicone resins and the like. Among these, it is preferable to use an acrylic resins that can obtain high transparency when, for example, a laminated thin film is used as an optical application.

The acrylic ultraviolet ray-curable resin is not particularly limited, but may be appropriately selected and blended from, for example, a monofunctional, bifunctional, or trifunctional or higher polyfunctional acrylic monomer, oligomer, polymer component, or the like in view of hardness, adhesion, workability, and the like. A photopolymerization initiator is blended with the ultraviolet ray-curable resin.

As specific examples of monofunctional acrylate components, carboxylic acids (acrylic acid), hydroxyls (2-hydroxyethyl acrylate, 2-hydroxypropyl acrylate, 4-hydroxybutyl acrylate), monomers of alkyls or alicyclics (isobutyl acrylate, t-butyl acrylate, isooctyl acrylate, lauryl acrylate, stearyl acrylate, isobornyl acrylate, cyclohexyl acrylate), other functional monomers (2-methoxyethyl acrylate, methoxyethylene glycol acrylate, 2-ethoxyethyl acrylate, tetrahydrofurfuryl acrylate, benzyl acrylate, ethylcarbitol acrylate, phenoxyethyl acrylate, N,N-dimethylaminoethyl acrylate, N,N-dimethylaminopropyl acrylamide, N,N-dimethylacrylamide, acryloylmorpholine, N-isopropylacrylamide, N,N-diethylacrylamide, N-vinylpyrrolidone, 2-(perfluorooctyl)ethyl acrylate, 3-perfluorohexyl-2-hydroxypropyl acrylate, 3-perfluorooctyl-2-hydroxypropyl-acrylate, 2-(perfluorodecyl)ethyl-acrylate, 2-(perfluoro-3-methylbutyl)ethyl acrylate), 2,4,6-tribromophenol acrylate, 2,4,6-tribromophenol methacrylate, 2-(2,4,6-tribromophenoxy)ethyl acrylate), 2-ethylhexyl acrylate, nonylphenol EO-modified acrylate, and the like can be mentioned.

As specific examples of bifunctional acrylate components, polyethylene glycol (600) diacrylate, dimethyloltricyclodecane diacrylate, bisphenol AEO-modified diacrylate, 1,9-nonanediol diacrylate, 1,10-decanediol diacrylate, propoxylated bisphenol A diacrylate, tricyclodecane dimethanol diacrylate, diethylene glycol diacrylate, neopentyl glycol diacrylate, 1,4-butanediol diacrylate, polyethylene glycol (200) diacrylate, tetraethylene glycol diacrylate, polyethylene glycol (400) diacrylate, cyclohexanedimethanol diacrylate, aliphatic urethane acrylate, a polyether urethane acrylate, and the like can be mentioned. Specific examples available on the market include the product name "SR610" from Sartomer Co., Ltd.

As specific examples of trifunctional or higher acrylate components, pentaerythritol triacrylate (PETA), 2-hydroxy-3-acryloyloxypropyl methacrylate, EO-converted triacrylate of isocyanuric acid, ε-caprolactone-modified tris-(2-acryloxyethyl) isocyanurate, trimethylolpropane triacrylate (TMPTA), ε-caprolactone-modified tris (acryloxyethyl) acrylate, tris-(2-acryloxyethyl) isocyanurate, and the like can be mentioned. Specific examples available on the market include the product name "CN968" from Sartomer and the product name "SR444" from Sartomer.

As specific examples of photopolymerization initiators, an alkylphenone-based photopolymerization initiator, an acylphosphine oxide-based photopolymerization initiator, a titanocene-based photopolymerization initiator, and the like can be mentioned. Specific examples available on the market include 1-hydroxycyclohexyl phenyl ketone (IRGACURE184, BASF Japan Ltd.) and the like.

Moreover, the acrylic ultraviolet ray-curable resin preferably contains a leveling agent for improving smoothness. As specific examples of leveling agents, silicone-based leveling agents, fluorine-based leveling agents, acrylic leveling agents, and the like can be mentioned, and one type or two or more types of these may be used. Among these, it is preferable to use a silicone-based leveling agent from the perspective of coating film properties. Specific examples available on the market include the product name "BYK337" (polyether-modified polydimethylsiloxane) from BYK Japan KK.

Furthermore, the solvent used in acrylic ultraviolet ray -curable resins is not particularly limited so long as the coating properties of the resin composition are satisfactory, but it is preferred to select in consideration of safety. As specific examples of solvents, propylene glycol monomethyl ether acetate, butyl acetate, methyl 3-ethoxypropionate, ethyl 3-ethoxypropionate, ethyl cellosolve acetate, ethyl lactate, methyl 3-methoxypropionate, 2-heptanone, cyclohexanone, ethyl carbitol acetate, butyl carbitol acetate, propylene glycol methyl ether, and the like can be mentioned, and one or two or more of these may be used. Among these, propylene glycol monomethyl ether acetate and butyl acetate are preferably used from the perspective of coating properties. Furthermore, the acrylic ultraviolet ray-curable resin may contain, in addition to the photopolymerization initiator, leveling agent and solvent, a functionality imparting agent such as a hue modifier, a colorant, an ultraviolet ray absorber, an antistatic agent, various thermoplastic resin materials, a refractive index adjusting resin, refractive index adjusting particles, and adhesiveness imparting resin.

Furthermore, metal oxide fine particles (not illustrated) may be dispersed and contained in the above resin of the hard-coat layer 12. Here, the metal oxide fine particles included in the hard-coat layer 12 of the present embodiment are, unlike micro-order filler particles (average particle size 1 μm or more) for forming the conventional protruding structure described in Patent Documents 1 and 2, are nano-order fine particles (average particle size less than 1 μm) whose particle size is smaller than the filler particles. The adhesion between the hard-coat layer 12 and the adhesive layer 13 can be enhanced by containing the nano-order metal oxide fine particles in the hard-coat layer 12.

The metal oxide fine particles are granulated metal oxides. The average particle size of the metal oxide fine particles is preferably 800 nm or less, and more preferably 20 to 100 nm. When the average particle size of the metal oxide fine particles is larger than 800 nm, it becomes difficult to use the laminated thin film for optical applications. Meanwhile, if the average particle size of the metal oxide fine particles is smaller than 20 nm, the adhesion between the hard-coat layer 12 and the adhesive layer 13 decreases. Therefore, by setting the average particle size of the metal oxide fine particles of the present embodiment to be within the above range, the optical laminate 10 can be suitably applied to optical applications, and the adhesion between the hard-coat layer 12 and the adhesive layer 13 can be improved. Note that in the present embodiment, average particle size refers to a value measured by the BET method.

The content of the metal oxide fine particles is preferably 20 to 50% by mass relative to the total solid content of the resin composition of the hard-coat layer 12. If the content of the metal oxide fine particles is too small, the adhesion between the hard-coat layer 12 and the adhesive layer 13 decreases. Meanwhile, if the content of the metal oxide fine particles is too large, the flexibility and the like of the hard-coat layer 12 decreases. Therefore, by setting the content of the metal oxide fine particles of the present embodiment to be within the above range, the decrease of the flexibility and the like of the hard-coat layer 12 can be suppressed while improving the adhesion between the hard-coat layer 12 and the adhesive layer 13. Note that the solid content of the resin composition is the entire component other than the solvent, and a liquid monomer component is also included in the solid content.

As specific examples of the metal oxide constituting the metal oxide fine particles, $SiO_2$ (silica), $Al_2O_3$ (alumina), $TiO_2$ (titania), $ZrO_2$ (zirconia), $CeO_2$ (ceria), MgO (magnesia), ZnO, $Ta_2O_5$, $Sb_2O_3$, $SnO_2$, $MnO_2$, and the like can be mentioned. Among these, it is preferable to use a silica that can obtain high transparency when, for example, a laminated thin film is used as an optical application. Specific examples available on the market include the product name "IPA-ST-L" (silica sol) from Nissan Chemical Corporation. Furthermore, a functional group such as an acryl group or an epoxy group may be introduced on the surface of the metal oxide fine particles in order to increase adhesion and affinity with the resin.

Furthermore, the hard-coat layer 12 of the present embodiment may contain the nano-order metal oxide fine particles described above, but does not contain filler particles whose average particle size is 1 $\mu$m or more (micro-order particles for forming a conventional protruding structure described in patent documents 1 and 2 described above). However, with the hard-coat layer 12 of the present embodiment, because the concave/convex structure 30 is formed on the surface of the adhesive layer 13 side without including the filler particles, anti-glare properties can be imparted to the optical laminate 10 by the concave/convex structure 30. Note that a configuration of the concave/convex structure 30 of the hard-coat layer 12 and a method for forming the concave/convex structure 30 will be described in detail below.

The thickness of the hard-coat layer 12 is not particularly limited, but is, for example, preferably 0.5 $\mu$m or more, and more preferably 1 $\mu$m or more. When the thickness of the hard-coat layer 12 is 0.5 $\mu$m or more, a sufficient hardness is obtained, and therefore scratches are less likely to occur during manufacture. Moreover, the thickness of the hard-coat layer 12 is preferably 100 $\mu$m or less. When the thickness of the hard-coat layer 12 is 100 $\mu$m or less, the optical laminate 10 can be reduced in thickness and weight. When the thickness of the hard-coat layer 12 is 100 $\mu$m or less, microcracks hardly occur in the hard-coat layer 12 which occur when the optical laminate 10 during manufacture is bent, and productivity is improved.

The hard-coat layer 12 may be a single layer or a plurality of laminated layers. Moreover, the hard-coat layer 12 may be further imparted with well-known functions such as ultraviolet ray absorption performance, antistatic performance, a refractive index adjusting function, a hardness adjusting function, and the like. Moreover, a function imparted to the hard-coat layer 12 may be imparted in a single hard-coat layer or imparted by being divided into a plurality of hard-coat layers.

[Adhesive Layer 13]

The adhesive layer 13 is a layer formed to improve adhesion between the hard-coat layer 12 as an organic film and the antireflective layer 14 as an inorganic film. The adhesive layer 13 is preferably composed of an oxygen-deficient metal oxide or metal. An oxygen deficient metal oxide is a metal oxide in a state in which the number of oxygens is less than the stoichiometric composition. As examples of the oxygen deficient metal oxide, SiOx, AlOx, TiOx, ZrOx, CeOx, MgOx, ZnOx, TaOx, SbOx, SnOx, MnOx, and the like can be mentioned. Furthermore, examples of metals include Si, Al, Ti, Zr, Ce, Mg, Zn, Ta, Sb, Sn, Mn, In, and the like. The adhesive layer 13 may have, for example, an x value in SiOx of greater than 0 and less than 2.0. Moreover, the adhesive layer 13 may be formed from a mixture of a plurality of types of metals or metal oxides.

Note that when the adhesive layer 13 is configured by SiOx, the refractive index of the adhesive layer 13 is preferably 1.20 to 1.60. In other words, when the adhesive layer 13 is configured by SiOx, the adhesive layer 13 also functions as a low refractive index layer 14b that will be described below.

From the perspective of maintaining transparency and adhesion to the antireflective layer 14 and obtaining favorable optical characteristics, the thickness of the adhesive layer 13 is preferably greater than 0 nm and equal to or less than 20 nm, and is particularly preferably 1 to 10 nm.

It is preferable to provide the adhesive layer 13 between the hard-coat layer 12 and the antireflective layer 14 because the adhesion of both layers can be improved. However, the adhesive layer 13 is not essential, and the antireflective layer 14 may be directly laminated on the hard-coat layer 12.

[Antireflective Layer 14]

The antireflective layer 14 is an example of a metal oxide layer provided on the hard-coat layer 12. The antireflective layer 14 is an example of an optical functional layer. The antireflective layer 14 is a laminate exhibiting an antireflection function. As illustrated in FIG. 1, the antireflective layer 14 is configured from a laminate in which a low refractive index layer 14b and a high refractive index layer 14a are laminated alternatingly. In the present embodiment, the antireflective layer 14 is a total of four layers laminated in order from the adhesive layer 13 side, alternatingly the high refractive index layer 14a and the low refractive index layer 14b. The number of layers of the high refractive index layer 14a and the low refractive index layer 14b is not particularly limited, and the number of layers of the high refractive index layer 14a and the low refractive index layer 14b may be any number of layers.

As illustrated in FIG. 1, the antifouling layer 15 contacts the low refractive index layer 14b that configures the antireflective layer 14. Therefore, light incident from the antifouling layer 15 side is diffused by the antireflective layer 14. Thus, an antireflection function for preventing light incident from the antifouling layer 15 side from being reflected in one direction is obtained.

The low refractive index layer 14b preferably contains an Si oxide from the perspective of ease of acquisition and cost, and is preferably a layer having $SiO_2$ (an Si oxide) or the like as a main component. The $SiO_2$ monolayer film is colorless and transparent. In the present embodiment, the main component of the low refractive index layer 14b signifies that a component is included at 50% by mass or more in the low refractive index layer 14b.

When the low refractive index layer 14b is a layer having an Si oxide as a main component, other elements may be included at less than 50% by mass. The content of an element other than the Si oxide is preferably 10% or less. As another element, for example, Na for the purpose of improving durability, Zr, Al, or N for the purpose of improving hardness, and Zr or Al for the purpose of improving alkali resistance may be included.

The refractive index of the low refractive index layer 14b is preferably 1.20 to 1.60, more preferably 1.30 to 1.50. As the dielectric used in the low refractive index layer 14b, magnesium fluoride ($MgF_2$, refractive index 1.38) and the like can be mentioned.

The refractive index of the high refractive index layer 14a is preferably 2.00 to 2.60, more preferably 2.10 to 2.45. As the dielectric used for the high refractive index layer 14a, niobium pentoxide ($Nb_2O_5$, refractive index 2.33), titanium oxide ($TiO_2$, refractive index 2.33 to 2.55), tungsten oxide ($WO_3$, refractive index 2.2), cerium oxide ($CeO_2$, refractive index 2.2), tantalum pentoxide ($Ta_2O_5$, refractive index 2.16), zinc oxide (ZnO, refractive index 2.1), indium tin oxide (ITO, refractive index 2.06), zirconium oxide ($ZrO_2$, refractive index 2.2), and the like can be mentioned.

When it is desired to impart conductive characteristics to the high refractive index layer 14a, for example, ITO or indium zinc oxide (IZO) may be selected.

For example, it is preferable to use niobium pentoxide (NbaOs, refractive index 2.33) as the high refractive index layer 14a and $SiO_2$ as the low refractive index layer 14b for the antireflective layer 14.

The film thickness of the low refractive index layer 14b may be in a range of 1 to 200 nm, and is appropriately selected according to the wavelength range in which an antireflection function is required.

The film thickness of the high refractive index layer 14a may be, for example, 1 to 200 nm, and is appropriately selected according to the wavelength range in which an antireflection function is required.

The film thicknesses of the high refractive index layer 14a and the low refractive index layer 14b may be appropriately selected according to the design of the antireflective layer 14. For example, a high refractive index layer 14a of 5 to 50 nm, a low refractive index layer 14b of 10 to 80 nm, a high refractive index layer 14a of 20 to 200 nm, and a low refractive index layer 14b of 50 to 200 nm may be formed in this order from the adhesive layer 13 side.

A low refractive index layer 14b is arranged on the antifouling layer 15 side among the layers forming the antireflective layer 14. When the low refractive index layer 14b of the antireflective layer 14 is in contact with the antifouling layer 15, the antireflection performance of the antireflective layer 14 is favorable, and this is therefore preferable.

Note that in the present embodiment, an example of the antireflective layer 14 is given as the optical functional layer provided on the hard-coat layer 12, but the optical functional layer is not limited to such an example. The optical function layer is a layer that exhibits an optical function. The optical function is a function that controls reflection, transmission, and refraction that are properties of light. Examples include an antireflection function, a selective reflection function, an anti-glare function, a lens function, and the like. In addition to the antireflective layer 14, the optical functional layer may be, for example, a selective reflection layer, an anti-glare layer, or the like. As the selective reflection layer and the anti-glare layer, a known layer can be used. Each of the antireflective layer, the selective reflection layer and the anti-glare layer may be a single layer or may be a laminate of a plurality of layers.

[Antifouling Layer 15]

The antifouling layer 15 is formed on the outermost surface of the antireflective layer 14 to prevent the antireflective layer 14 from being soiled. Furthermore, the antifouling layer 15 suppresses wear of the antireflective layer 14 by wear resistance when applied to a touch panel or the like.

The antifouling layer 15 of the present embodiment is formed from a vapor deposition film in which an antifouling material is vapor deposited. In the present embodiment, the antifouling layer 15 is formed by vacuum vapor depositing a fluorine-based organic compound as an antifouling material on one surface of the low refractive index layer 14b that configures the antireflective layer 14. In the present embodiment, the antifouling material contains a fluorine-based organic compound, resulting in the optical laminate 10 having further favorable friction resistance and alkali resistance.

As the fluorine-based organic compound constituting the antifouling layer 15, a compound composed of a fluorine-modified organic group and a reactive silyl group (for example, alkoxysilane) is preferably used. The fluorine-based organic compound constituting the antifouling layer 15 is, for example, a silane compound having a fluoroalkyl chain or an alkoxysilane compound having a perfluoropolyether group. Examples of commercial products include the Optool DSX (manufactured by Daikin Industries, Ltd.) and the KY-100 series (manufactured by Shin-Etsu Chemical Co., Ltd.).

By using an alkoxysilane compound having a perfluoropolyether group as the fluorine-based organic compound constituting the antifouling layer 15, the contact angle of the antifouling layer 15 with water can be set at 110 degrees or more, and water repellency and antifouling properties can be improved.

When a compound composed of a fluorine-modified organic group and a reactive silyl group (for example, alkoxysilane) is used as the fluorine-based organic compound constituting the antifouling layer 15 and a compound composed of $SiO_2$ is used as the low refractive index layer 14b of the antireflective layer 14 contacting the antifouling layer 15, a siloxane bond is formed between the silanol group which is the skeleton of the fluorine-based organic compound and $SiO_2$. Therefore, adhesion between the antireflective layer 14 and the antifouling layer 15 is favorable and preferable.

The optical thickness of the antifouling layer 15 may be in the range of 1 to 20 nm, preferably in the range of 3 to 10 nm. When the thickness of the antifouling layer 15 is 1 nm or more, it is possible to sufficiently ensure wear resistance when the optical laminate 10 is applied to a touch panel or the like. Furthermore, if the thickness of the antifouling layer 15 is 20 nm or less, the time required for vapor deposition can completed in a short period of time and manufacture can be performed efficiently.

The antifouling layer 15 may contain additives such as a light stabilizer, an ultraviolet ray absorber, a colorant, an antistatic agent, a lubricant, a leveling agent, an antifoaming agent, an antioxidant, a flame retardant, an infrared ray absorber, a surfactant, and the like, as necessary.

The antifouling layer 15 formed by vapor deposition is firmly bonded to the antireflective layer 14, and has few voids and is dense. Thus, the antifouling layer 15 of the present embodiment exhibits characteristics different from those of the antifouling layer formed by a conventional method such as an application of an antifouling material.

[2. Concave/Convex Structure 30 of the Hard-Coat Layer 12]

Next, a concave/convex structure of the hard-coat layer 12 of the present embodiment will be described with reference to FIGS. 1 to 4.

FIG. 2 is a cross-sectional view illustrating an example of the hard-coat layer 12 of the present embodiment. As illustrated in FIG. 2, an concave/convex structure 30 is formed on the surface of the adhesive layer 13 side of the hard-coat layer 12 of the present embodiment. The concave/convex structure 30 is configured by a plurality of convex portions 32 and a plurality of concave portions 34. Tops 32a of the plurality of convex portions 32 configuring the concave/convex structure 30 of the hard-coat layer 12 have substantially the same height as each other, and each of the tops 32a has a substantially flat face. Moreover, the plurality of concave portions 34 configuring the concave/convex structure 30 of the hard-coat layer 12 do not penetrate the hard-coat layer 12. In other words, bottoms 34a of the concave portions 34 of the hard-coat layer 12 do not contact the surface of the transparent substrate 11.

Furthermore, as described above, the thickness of the adhesive layer 13 (for example, about 0.005 μm), the thickness of the antireflective layer 14 (for example, about 0.2 μm), and the thickness of the antifouling layer 15 (for example, about 0.005 μm) are significantly thinner than the thickness of the hard-coat layer 12 (for example, 5 to 10 μm). Therefore, the adhesive layer 13, the antireflective layer 14, and the antifouling layer 15 are formed to conform to the concave/convex structure 30 of the hard-coat layer 12.

Therefore, as illustrated in FIG. 1, the surface of the adhesive layer 13 is an uneven surface 40 that conforms to the shape of the concave/convex structure 30 of the hard-coat layer 12. Because of this, the tops of the plurality of convex portions configuring the uneven surface 40 of the adhesive layer 13 have substantially the same height as each other similarly to the tops 32a of the convex portions 32 of the hard-coat layer 12, and each of the tops has a substantially flat face.

Similarly, the surface of the antireflective layer 14, that is, the surface of the high refractive index layer 14a and the surface of the low refractive index layer 14b, are uneven surfaces 50a, 50b that conform to the shape of the concave/convex structure 30 of the hard-coat layer 12. Because of this, the tops of the plurality of convex portions configuring the uneven surface 50a of the high refractive index layer 14a and the tops of the plurality of convex portions configuring the uneven surface 50b of the low refractive index layer 14b have substantially the same height as each other similarly to the tops 32a of the convex portions 32 of the hard-coat layer 12, and each of the tops has a substantially flat face.

Moreover, the surface of the antifouling layer 15, that is, the outermost surface of the optical laminate 10, is the uneven surface 60 that conform to the shape of the concave/convex structure 30 of the hard-coat layer 12. For this reason, the uneven surface 60 formed on the outermost surface of the optical laminate 10 is configured by a plurality of convex portions 62 and a plurality of concave portions 64. Therefore, the plurality of convex portions 62 configuring the uneven surface 60 have the same shape as the plurality of convex portions 32 of the hard-coat layer 12. In other words, the tops 62a of the plurality of convex portions 62 configuring the uneven surface 60 have substantially the same height as each other, similarly to the tops 32a of the convex portions 32 of the hard-coat layer 12, and each of the tops 62a has a substantially flat face. Moreover, the plurality of concave portions 64 configuring the uneven surface 60 have the same shape as the plurality of concave portions 34 of the hard-coat layer 12.

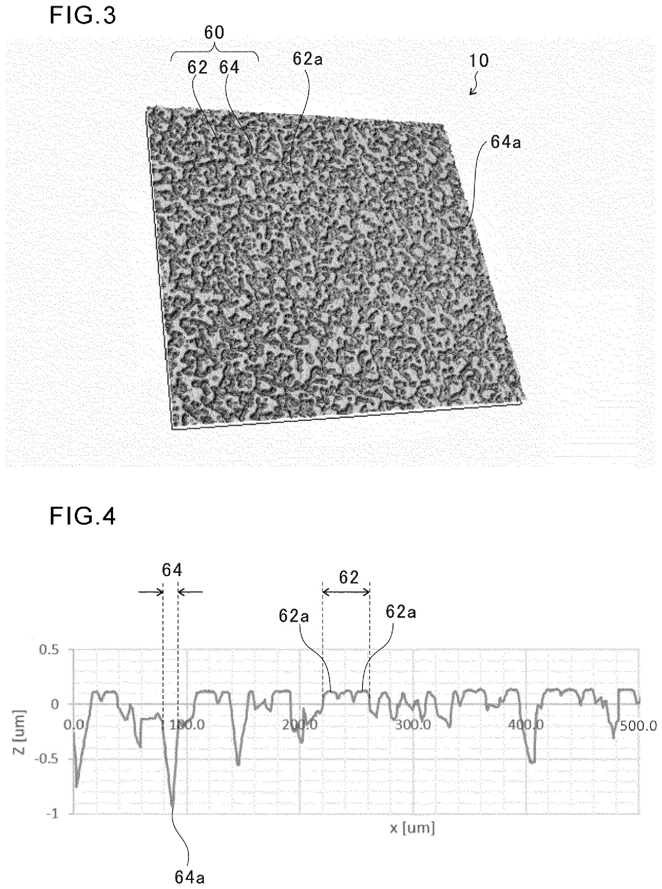

FIG. 3 is a diagram illustrating a 3D image of an example of the optical laminate 10 of the present embodiment. FIG. 4 is a diagram illustrating a cross-sectional roughness of an example of the optical laminate 10 of the present embodiment.

As illustrated in FIG. 3, the outermost surface of the optical laminate 10 is an uneven surface 60 configured from the plurality of convex portions 62 and the plurality of concave portions 64. In the uneven surface 60, the plurality of convex portions 62 are formed in a floating island shape arranged dispersed randomly in the surface direction. The individual convex portions 62 have a generally frustum shape, but the planar shape of the convex portions 62 is random. Similarly, the plurality of convex portions 32 configuring the concave/convex structure 30 of the hard-coat layer 12 is also formed in a floating island shape arranged dispersed randomly in the surface direction.

Furthermore, the tops 62a of the plurality of convex portions 62 configuring the uneven surface 60 of the optical laminate 10 have substantially the same height as each other. Therefore, it can be said that the tops 32a of the plurality of convex portions 32 configuring the concave/convex structure 30 of the hard-coat layer 12 have substantially the same height as each other. Here, "substantially the same height" means, for example, as illustrated in FIG. 4, a structure in which a stress a load of an object in contact with the optical laminate 10, for example, a finger of an operator, a stylus pen (pointing device), or the like, can be uniformly dispersed by substantially equalizing the heights of the many convex portions 62 formed on the surface of the optical laminate 10. When the heights of the tops 62a of the plurality of convex portions 62 have "substantially the same height as each other", the height variation of the tops 62a (that is, the height difference between the plurality of tops 62a) of the plurality of convex portions 62 may be within 0.5 $\mu$m, and more preferably within 0.2 $\mu$m. Similarly, when the heights of the tops 32a of the plurality of convex portions 32 have "substantially the same height as each other", the heights of the tops 32a (that is, the height difference between the plurality of tops 32a) of the plurality of convex portions 32 may be within 0.5 $\mu$m, and more preferably within 0.2 $\mu$m.

Furthermore, each of the tops 62a of the plurality of convex portions 62 configuring the uneven surface 60 of the hard-coat layer 12 more preferably has a substantially flat face (top surface). Here, "substantially flat face" includes when a flat face has fine irregularities formed thereon in addition to when the tops 62a of the convex portions 62 have a perfect flat face. The flat surface has fine irregularities formed thereon means, for example, a flat surface in which the difference in height between the fine irregularities is $\pm$0.3 $\mu$m or less, preferably $\pm$0.1 $\mu$m or less with respect to the reference surface of the tops 62a. The reference plane is a completely flat plane virtually set to a desired height position of the convex portions 62.

Similarly, each of the tops 32a of the plurality of convex portions 32 configuring the concave/convex structure 30 of the optical laminate 10 more preferably has a substantially flat surface (top surface). Here, "substantially flat face" includes when a flat face has fine irregularities formed thereon in addition to when the tops 32a of the convex portions 32 have a perfect flat face. The flat face has fine irregularities formed thereon means, for example, a flat face in which the difference in height between the fine irregularities is $\pm$0.3 $\mu$m or less, preferably $\pm$0.1 $\mu$m or less with respect to the reference surface of the tops 32a. The reference plane is a completely flat plane virtually set to a desired height position of the convex portions 32.

Furthermore, as illustrated in FIG. 3, the plurality of concave portions 64 are scattered randomly and dispersed in the surface direction on the uneven surface 60 of the optical laminate 10. Each of the concave portions 64 is, for example, a recessed portion having a random planar shape, and the depths of the bottoms 64a of the concave portions 64 are also random. Similarly, the plurality of concave portions 34 configuring the concave/convex structure 30 of the hard-coat layer 12 are also scattered randomly and dispersed in the surface direction, the planar shape of each concave portion 34 is also random, and the depths of the bottoms 34a of the concave portions 34 are also random.

Furthermore, as illustrated in FIG. 4, the height difference between the tops 62a of the convex portions 62 and the bottoms 64a of the concave portions 64 on the uneven surface 60 of the optical laminate 10 is, for example, about 0.4 to 1 $\mu$m. Similarly, the height difference between the tops 32a of the convex portions 32 and the bottoms 34a of the concave portions 34 on the concave/convex structure 30 of the hard-coat layer 12 is, for example, about 0.4 to 1 $\mu$m.

In this manner, the hard-coat layer 12 has the concave/convex structure 30, that is, the uneven surface 60 is formed on the outermost surface of the optical laminate 10. Thus, since incident light is scattered on the uneven surface 60 of the optical laminate 10, the optical laminate 10 can exhibit anti-glare properties.

Moreover, the height distribution of the surface of the concave/convex structure 30 of the hard-coat layer 12 of the present embodiment satisfies the following formula (1).

$$A/1.9 < P \quad (1)$$

A: The height of the highest point on the surface of the concave/convex structure 30 when the height B of the lowest point on the surface of the concave/convex structure 30 is defined as 0

P: The mode of the height distribution of the surface of the concave/convex structure 30 when the height B of the lowest point on the surface of the concave/convex structure 30 is defined as 0

In other words, P is the maximum point of distribution when the height distribution of the surface of the concave/convex structure 30 is expressed by a histogram.

When formula (1) is satisfied, in the concave/convex structure 30 of the hard-coat layer 12, more convex portions 32 having substantially flat tops 32a are distributed than convex portions having spindle or dome-shaped pointed tops, the distribution area of the flat tops 32a widens, and the heights of the flat tops 32a are generally uniform. Because of this, the concave/convex structure 30 becomes a rough surface structure that includes many tops 32a composed of a flat face and has excellent abrasion resistance. On the other hand, when the formula (1) is not satisfied, that is, when $A/1.9 \geq P$, in the concave/convex structure of the hard-coat layer, the distribution of the convex portions having the spindle or dome-shaped pointed tops increases, and the distribution area of the flat tops narrows. Therefore, the concave/convex structure becomes a protruding structure having pointed protrusions, and the abrasion resistance decreases.

As described above, the outermost surface of the optical laminate 10 according to the present embodiment becomes the uneven surface 60 that conforms to the shape of the concave/convex structure 30 of the hard-coat layer 12, and the tops 62a of the plurality of convex portions 62 configuring the uneven surface 60 have substantially the same height as each other, and each of the tops 62a of the plurality of convex portions 62 has a substantially flat face.

Therefore, a protruding structure having a protrusion that is pointed in a dome or a spindle shape as in conventional art is hardly formed on the outermost surface of the optical laminate 10. Therefore, the surface of the optical laminate 10 according to the present embodiment becomes a table-shaped rough surface structure where the tops 62a of the convex portions 62 are a substantially flat face. Thus, for example, when the optical laminate 10 is installed on a touch panel as an antireflection film, a load applied to the surface screen by an operator's finger, a pointing device, or the like can be dispersed at the tops 62a of the convex portions 62. Therefore, compared to a conventional optical laminate provided with a protruding structure having a protrusion pointed in a dome or spindle shape, the optical laminate 10 can suppress wear of the convex portions 62 and can improve abrasion resistance. Thus, the durability of the optical laminate 10 can be improved.

[3. Characteristics of the Optical Laminate 10]

Next, characteristics of the optical laminate 10 of the present embodiment will be described. The optical laminate 10 of the present embodiment has, for example, the following characteristics (A) to (C).

(A) Water contact angle (WCA)

A case is considered in which, in accordance with JIS L0849, using a rubbing tester using steel wool, a rubbing test is performed in which steel wool is rubbed against the surface of the optical laminate 10 under conditions of a load of 1 kg, a contact area of 1 cm × 1 cm, and 2,000 reciprocations. In the optical laminate 10 of the present embodiment, the contact angle with water of the outermost surface of the optical laminate 10 after the rubbing test is preferably 90 degrees or more.

When a protruding structure having pointed protrusions, as in conventional art, is formed on the outermost surface of the optical laminate, the protrusions are scraped and shavings are produced by the sliding of steel wool. Since the rubbing test is continued in a state in which shavings are interposed between the steel wool and the optical laminate, the antireflective layer and the antifouling layer are shaved from the hard-coat layer. In this case, since the antifouling layer is removed from the outermost surface of the optical laminate, the outermost surface of the optical laminate 10 is easily wetted, and the contact angle with water after the rubbing test becomes less than 90 degrees. That is, when the contact angle with water after the rubbing test is less than 90 degrees, the antifouling layer 15 is shaved along with the convex portions 62 that configure the uneven surface 60 of the optical laminate 10 by execution of the rubbing test, and thus, it can be said that abrasion resistance is low.

In contrast to this, the optical laminate 10 of the present embodiment has a characteristic where the contact angle with water of the outermost surface of the optical laminate 10 after rubbing is 90 degrees or more even after executing the rubbing test. Therefore, with the optical laminate 10 of the present embodiment, the convex portions 62 (antifouling layer 15) configuring the uneven surface 60 of the optical laminate 10 is hardly shaved even when the rubbing test is executed. Thus, the optical laminate 10 of the present embodiment has the uneven surface 60 that is resistant to scratching and has excellent abrasion resistance.

(B) Surface roughness Sa

The surface roughness Sa of the concave/convex structure 30 of the hard-coat layer 12 is preferably 50 to 300 nm. Note that surface roughness Sa means the arithmetic average height Sa (ISO25178).

If the surface roughness Sa is less than 50 nm, there is a problem that sufficient anti-glare properties cannot be exhibited, and if the surface roughness Sa is greater than 300 nm, there is a problem that it is difficult for the tops 62a of the plurality of convex portions 62 to be substantially the same height as each other, and sufficient abrasion resistance cannot be realized. In contrast to this, because the surface roughness Sa of the concave/convex structure of the hard-coat layer 12 of the optical laminate 10 of the present embodiment is 50 to 300 nm, anti-glare properties and abrasion resistance can be suitably realized.

(C) External haze value (Haze)

In the optical laminate 10 of the present embodiment, the external haze value defined by JIS K7136 is preferably 3 to 40%. The external haze value is obtained by digitizing the ratio of the diffused light component in the total light transmittance. The external haze value is a value obtained by removing a scattered component in the sample (optical laminate 10) from the haze value defined by JIS K7136.

If the external haze value of the optical laminate is less than 3%, there is a problem that sufficient anti-glare properties cannot be exhibited, and if the external haze value is greater than 40%, there is a problem that black reproducibility and image sharpness decrease when displaying an image. In contrast to this, because the external haze value of the optical laminate 10 of the present embodiment is 3 to 40%, anti-glare properties and high image display quality can be suitably realized.

As described above, the hard-coat layer 12 of the optical laminate 10 of the present embodiment has the concave/convex structure 30 on the micro order. This enables the optical laminate 10 of the present embodiment to exhibit anti-glare properties. Furthermore, the concave/convex structure 30 of the hard-coat layer 12 of the present embodiment is formed by the transferring described below that uses a transfer mold and, unlike the conventional art, is not formed by causing filler particles to be contained. Therefore, the tops 32a of the plurality of convex portions 32 constituting the concave/convex structure 30 of the present embodiment have substantially the same heights as each other, and each of the tops 32a of the plurality of convex portions 32 has a substantially flat face. Therefore, in the uneven surface 60 that is the outermost surface of the optical laminate 10 as well, the tops 62a of the plurality of convex portions 62 have substantially the same heights as each other, and each of the tops 62a of the plurality of convex portions 62 has a substantially flat face and is free from sharp, protruding convexities. This improves the abrasion resistance of the optical laminate 10. Thus, the optical laminate 10 can have improved abrasion resistance while maintaining anti-glare properties.

[4. Method for Manufacturing Optical Laminate 10]

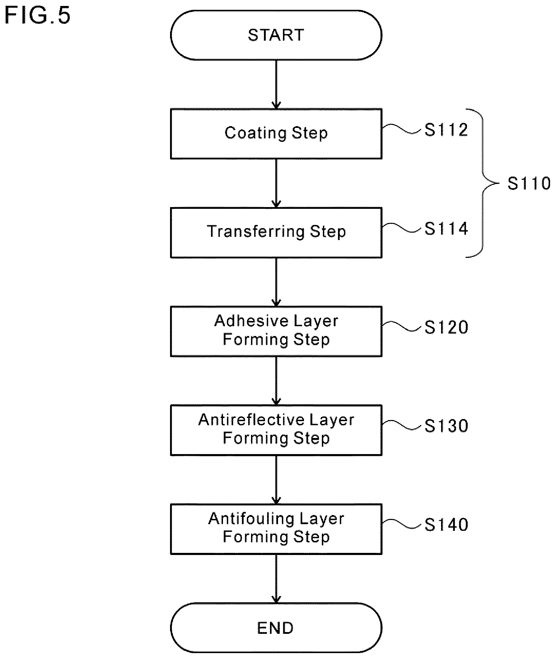

FIG. 5 is a flowchart illustrating a method for manufacturing the optical laminate 10 of the present embodiment.

As illustrated in FIG. 5, the method for manufacturing the optical laminate 10 of the present embodiment includes a step S 110 of forming the hard-coat layer, a step S 120 of forming the adhesive layer, a step S 130 of forming the antireflective layer, and a step S140 of forming the antifouling layer. Each step is described below.

[Step S110 of Forming Hard-Coat Layer]

The step S110 of forming the hard-coat layer is a step of providing the hard-coat layer 12 on the transparent substrate 11.

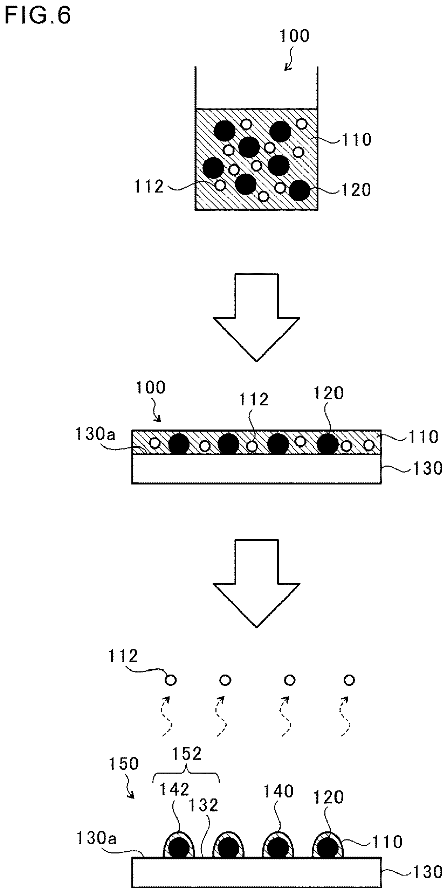

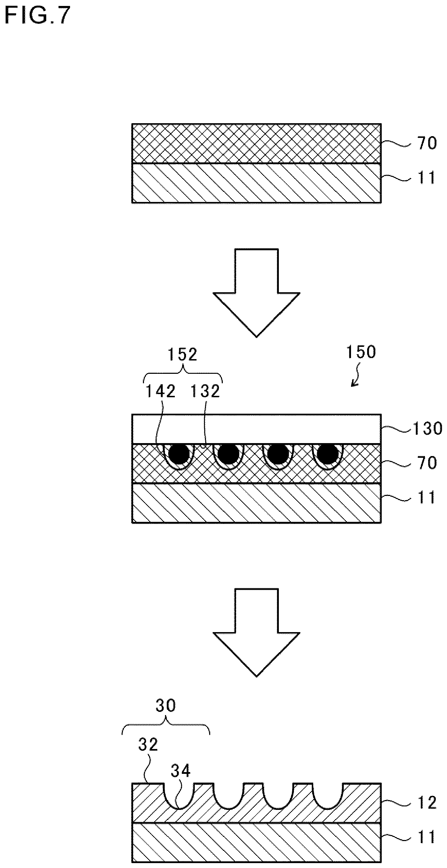

In the present embodiment, the step S110 of forming the hard-coat layer includes a coating step S 112 and a transferring step S114. In the transferring step S 114 of the step S110 of forming the hard-coat layer, a transfer mold is used to transfer the above concave/convex structure 30 into the surface of the hard-coat layer 12. In the following, first, a method for manufacturing the transfer mold of the present embodiment is described with reference to FIG. 6. Next, the coating step S 112 and the transferring step S114 are described with reference to FIG. 7.

FIG. 6 is a process diagram for describing one example of a method for manufacturing a transfer mold 150 of the present embodiment. In FIG. 6, the black circles represent filler particles 120, and the white circles represent a solvent 112. As illustrated in FIG. 6, first, a resin 100 for the transfer mold is prepared. The resin 100 is, for example, a binder resin 110 in which the filler particles 120 are dispersed. The binder resin 110 constituting the resin 100 is not particularly limited but is preferably a transparent binder resin through which energy rays such as ultraviolet rays, infrared rays, and electron rays can be transmitted. For example, an energy-ray-setting resin, which is a resin set by ultraviolet rays, infrared rays, or electron beams; a thermoplastic resin; or a thermosetting resin can be used.

As the energy-ray-setting resin used as the binder resin 110, ethyl (meth)acrylate, ethylhexyl (meth)acrylate, styrene, methyl styrene, N-vinylpyrrolidone, carboxyl acids (acrylic acid), hydroxyls (2-hydroxyethyl acrylate, 2-hydroxypropyl acrylate, 4-hydroxybutyl acrylate), monomers of alkyls or alicyclics (isobutyl acrylate, t-butyl acrylate, isooctyl acrylate, lauryl acrylate, stearyl acrylate, isobomyl acrylate, cyclohexyl acrylate), other functional monomers (2-methoxyethyl acrylate, methoxyethylene glycol acrylate, 2-ethoxyethyl acrylate, tetrahydrofurfuryl acrylate, benzyl acrylate, ethylcarbitol acrylate, phenoxyethyl acrylate, N,N-dimethylaminoethyl acrylate, N,N-dimethylaminopropyl acrylamide, N,N-dimethylacrylamide, acryloylmorpholine, N-isopropylacrylamide, N,N-diethylacrylamide, N-vinylpyrrolidone, 2-(perfluorooctyl)ethyl acrylate, 3-perfluorohexyl-2-hydroxypropyl acrylate, 3-perfluorooctyl-2-hydroxypropyl-acrylate, 2-(perfluorodecyl)ethyl-acrylate, 2-(perfluoro-3-methylbutyl)ethyl acrylate), 2,4,6-tribromophenol acrylate, 2,4,6-tribromophenol methacrylate, 2-(2,4,6-tribromophenoxy)ethyl acrylate), 2-ethylhexyl acrylate, nonylphenol EO-modified acrylate, and the like can be mentioned.

As a compound that is an energy-ray-setting resin having two or more unsaturated bonds, for example, a multifunctional compound such as trimethylolpropane tri(meth)acrylate, tripropylene glycol di(meth)acrylate, diethylene glycol di(meth)acrylate, dipropylene glycol di(meth)acrylate, pentaerythritol tri(meth)acrylate, pentaerythritol tetra(meth)acrylate, dipentaerythritol hexa(meth)acrylate, 1,6-hexanediol di(meth)acrylate, neopentyl glycol di(meth)acrylate, trimethylolpropane tri(meth)acrylate, ditrimethylolpropane tetra(meth)acrylate, dipentaerythritol penta(meth)acrylate, tripentaerythritol octa(meth)acrylate, tetrapentaerythritol deca(meth)acrylate, isocyanuric-acid tri(meth)acrylate, isocyanuric-acid di(meth)acrylate, polyester tri(meth)acrylate, polyester di(meth)acrylate, bisphenol di(meth)acrylate, diglycerine tetra(meth)acrylate, adamantyl di(meth)acrylate, isobomyl di(meth)acrylate, dicyclopentane di(meth)acrylate, tricyclodecane di(meth)acrylate, ditrimethylolpropane tetra(meth)acrylate, polyethylene glycol (600) diacrylate, dimethylol-tricyclodecane diacrylate, bisphenol AEO-modified diacrylate, 1,9-nonanediol diacrylate, 1,10-decanediol diacrylate, propoxylated bisphenol A diacrylate, tricyclodecanedimethanol diacrylate, diethylene glycol diacrylate, neopentyl glycol diacrylate, 1,4-butanediol diacrylate, polyethylene glycol (200) diacrylate, tetraethylene glycol diacrylate, polyethylene glycol (400) diacrylate, cyclohexanedimethanol diacrylate, aliphatic urethane acrylate, polyether-based urethane acrylate, 2-hydroxy-3-acryloyloxypropyl methacrylate, isocyanuric-acid EO-modified triacrylate, $\varepsilon$-caprolactone-modified tris-(2-acryloxyethyl)isocyanurate, trimethylolpropane triacrylate (TMPTA), $\varepsilon$-caprolactone-modified tris (acroxyethyl) acrylate, or tris-(2-acryloxyethyl)isocyanurate can be mentioned. Among these, pentaerythritol triacrylate (PETA), dipentaerythritol hexaacrylate (DPHA), and pentaerythritol tetraacrylate (PETTA) are suitably used. "(Meth)acrylate" refers to methacrylate and acrylate. As the energy-ray-setting resin, one in which the compound described above is modified by PO (propylene oxide), EO (ethylene oxide), CL (caprolactone), or the like can also be used.

As the thermoplastic resin used as the binder resin 110, for example, a styrene resin, a (meth)acrylic resin, a vinyl acetate resin, a vinyl ether resin, a halogen-containing resin, an alicyclic olefin resin, a polycarbonate resin, a polyester resin, a polyamide resin, a cellulose derivative, a silicone resin, and a rubber or elastomer can be mentioned. The above thermoplastic resin is preferably amorphous and soluble in an organic solvent (in particular, a common solvent that can dissolve a plurality of polymers and settable compounds). In particular, from the perspective of transparency and weather resistance, a styrene resin, a (meth)acrylic resin, an alicyclic olefin resin, a polyester resin, a cellulose derivative (such as a cellulose ester), or the like is preferable.

As the thermosetting resin used as the binder resin 110, for example, a phenol resin, a urea resin, a diallylphthalate resin, a melamine resin, a guanamine resin, an unsaturated polyester resin, a polyurethane resin, an epoxy resin, an aminoalkyd resin, a melamine-urea co-condensate resin, a silicone resin, and a polysiloxane resin (including so-called silsesquioxanes such as a cage-shaped resin, a ladder-shaped resin and the like) can be mentioned.

Here, as the binder resin 110, an ultraviolet ray-curable resin is mentioned as an example. A photopolymerization initiator is blended with the ultraviolet ray-curable resin.

As the filler particles 120 included in the binder resin 110, known particles can be used-for example, silica (oxide of Si) particles, alumina (aluminum oxide) particles, or other particles made of an inorganic oxide or organic particles. The average particle size of the silica particles, alumina particles, or other inorganic oxide particles as the filler particles 120 is not particularly limited but is preferably 0.5 to 10 $\mu$m and more preferably is 1 to 5 $\mu$m.

As the organic particles as the filler particles 120, for example, an acrylic resin can be mentioned. The particle size of the organic particles is not particularly limited but is preferably 0.5 to 10 $\mu$m and more preferably 1 to 5 $\mu$m.

The content of the binder resin 110 in the resin 100 is adjusted to be as low as possible so that the filler particles 120 are not buried in the binder resin 110 when the resin 100 is coated on a mold substrate 130 described below.

The prepared resin 100 is then coated on the surface 130a of the mold substrate 130. The mold substrate 130 is formed of, for example, a material through which ultraviolet rays can be transmitted. The mold substrate 130 may be formed of, for example, the same organic material or inorganic material as the above transparent substrate 11. The surface 130a on which the resin 100 is coated of the mold substrate 130 is substantially flat. Here, "substantially flat" means that there is no substantial difference in height across the entire surface 130a of the mold substrate 130. For example, the difference in height across the entire surface 130a of the mold substrate 130 may preferably be within 0.5 μm and more preferably be within 0.2 μm. Fine irregularities may be formed on the surface 130a of the mold substrate 130. The difference in height between the fine irregularities formed on the surface 130a is ±0.3 μm or less and preferably ±0.1 μm or less with respect to the reference plane of the surface 130a. The reference plane is a completely flat plane virtually set to a desired height position of the surface 130a.

Afterward, while drying the resin 100 coated on the mold substrate 130, ultraviolet rays are irradiated to the resin 100. This sets the ultraviolet-curable resin as the binder resin 110 included in the resin 100. The solvent 112 included in the resin 100 then vaporizes, and the binder resin 110 condenses around the filler particles 120.

A transfer mold 150 on which filler particles 120 covered in the binder resin 110 are interspersed is manufactured in this manner on the surface 130a of the mold substrate 130. The filler particles 120 covered in the binder resin 110 are made to be protrusions that protrude in a dome shape, a spindle shape, or any other shape on the surface 130a of the mold substrate 130. Hereinafter, the filler particles 120 covered in the binder resin 110 are simply referred to as "protrusions 140." A plurality of protrusions 140 is formed separated from each other on the flat surface 130a of the mold substrate 130. The flat surface 130a of the mold substrate 130 is exposed between adjacent protrusions 140. In this manner, a transfer mold 150 having a concave/convex shape 152 made of a plurality of convex portions 142 and a plurality of concave portions 132 is manufactured. The convex portions 142 of this concave/convex shape 152 are made of the above protrusions 140, and the bottoms of the concave portions 132 are the flat surface 130a of the mold substrate 130.

[Coating Step S112]

Next, the coating step S112 and transferring step S114 illustrated in FIG. 5 are described with reference to FIG. 7. FIG. 7 is a process diagram for describing the coating step S112 and the transferring step S114 of the present embodiment. The coating step S112 is a step of coating, for example, an energy-ray-setting resin composition 70 onto the surface of the transparent substrate 11. The energy-ray-setting resin composition 70 includes an energy-ray-setting resin that is not yet set, an energy-ray polymerization initiator, and metal-oxide fine particles.

The thickness (film thickness) of the energy-ray-setting resin composition 70 coated on the surface of the transparent substrate 11 is greater than the height of the protrusions 140 (convex portions 142) of the transfer mold 150 illustrated in FIG. 6.

[Transferring Step S114]

The transferring step S114 is a step of transferring the concave/convex shape 152 of the transfer mold 150 into the energy-ray-setting resin composition 70. Specifically, first, the concave/convex shape 152 of the transfer mold 150 is pressed against the energy-ray-setting resin composition 70. Energy rays are then irradiated, setting the energy-ray-setting resin composition 70. As above, the transfer mold 150 is transparent such that energy rays can be transmitted therethrough. Therefore, irradiating energy rays while pressing the concave/convex shape 152 of the transfer mold 150 against the energy-ray-setting resin composition 70 can set the energy-ray-setting resin composition 70 while transferring the concave/convex shape 152 of the transfer mold 150 into the energy-ray-setting resin composition 70.

When the transfer mold 150 is peeled away from the set energy-ray-setting resin composition 70, the hard-coat layer 12 having the concave/convex structure 30 is formed. The concave/convex structure 30 of the hard-coat layer 12 has a shape inverted from the concave/convex shape 152 of the transfer mold 150. Specifically, the convex portion 32 constituting the concave/convex structure 30 of the hard-coat layer 12 has a shape corresponding to the concave portion 132 of the concave/convex shape 152 of the transfer mold 150. The concave portion 34 constituting the concave/convex structure 30 of the hard-coat layer 12 has a shape corresponding to the convex portion 142 (protrusion 140) of the concave/convex shape 152 of the transfer mold 150.

As above, the surface 130a of the mold substrate 130 of the transfer mold 150 is substantially flat. Therefore, by transferring the concave/convex shape 152 of the transfer mold 150, the tops 32a of the plurality of convex portions 32 constituting the concave/convex structure 30 of the hard-coat layer 12 also come to have substantially the same heights as each other. As above, the difference in height between the fine irregularities in the surface 130a of the mold substrate 130 of the transfer mold 150 is ±0.3 μm or less with respect to the reference plane of the surface 130a. Therefore, by transferring the concave/convex shape 152 of the transfer mold 150, each of the tops 32a of the plurality of convex portions 32 constituting the concave/convex structure 30 of the hard-coat layer 12 also comes to have a substantially flat face.

The concave/convex shape 152 of the transfer mold 150 is adjusted to match the desired shape of the concave/convex structure 30 of the hard-coat layer 12. Specifically, in manufacturing the transfer mold 150, the particle size of the filler particles 120 included in the resin 100, the content of the filler particles 120, and the like are adjusted according to the desired shape of the concave/convex structure 30. For example, when the convex portion 32 of the concave/convex structure 30 of the hard-coat layer 12 is wanting to be increased in size, it is favorable to decrease the content of the filler particles 120. When the convex portion 32 of the concave/convex structure 30 of the hard-coat layer 12 is wanting to be decreased in size, it is favorable to increase the content of the filler particles 120. When the height of the convex portion 32 or the depth of the concave portion 34 of the concave/convex structure 30 of the hard-coat layer 12 is wanting to be increased, it is favorable to increase the particle size of the filler particles 120. When the height of the convex portion 32 or the depth of the concave portion 34 of the hard-coat layer 12 is wanting to be decreased, it is favorable to decrease the particle size of the filler particles 120.

As necessary, additional layers (not illustrated) may be provided on the surface of the transfer mold 150 (the filler particles 120 covered by the binder resin 110 and the surface 130a between the filler particles 120) for a purpose of reducing peeling of the transfer mold 150, protecting the shape of the surface, or the like. As examples of the layers, an inorganic layer and an antifouling layer, in this order from the binder-resin 110 side, can be mentioned. The antifouling layer improves release following shape transfer into the energy-ray-setting resin composition 70 (hard-coat layer 12). The inorganic layer has a function of more firmly binding the antifouling layer to the transfer mold 150. The inorganic layer can be provided by sputtering or vapor deposition, and the number of layers thereof can also be arbitrarily set. The antifouling layer may be of any material so long as a function of improving release from the hard-coat layer 12 is provided. For example, a silane compound having a fluoroalkyl group or other fluorine-containing group can be mentioned. As the method of forming the antifouling layer as well, coating and drying, vapor deposition, and the like can be mentioned. That is, when the intended shape can be transferred into the hard-coat layer 12, another optical laminate having a shape corresponding to this desired shape can be used as the transfer mold 150.

The step S110 of forming the hard-coat layer is not limited to the above and may be implemented by any known method. For example, it may be implemented by shape transferring using a rigid roll imparted with the desired shape or injection molding using a stamper or the like imparted with the desired shape.

[Step S120 of Forming Adhesive Layer]

Returning the description to FIG. 5, the step S120 of forming the adhesive layer is a step of forming the adhesive layer 13 on the surface of the hard-coat layer 12.

[Step S130 of Forming Antireflective Layer]

The step S130 of forming the antireflective layer is a step of forming the antireflective layer 14 on the surface of the adhesive layer 13. For example, the step S130 of forming the antireflective layer alternatingly forms a high refractive index layer 14a and a low refractive index layer 14b.

In the present embodiment, the step S120 of forming the adhesive layer and the step S130 of forming the antireflective layer are executed by sputtering. In the present embodiment, from the perspective of increasing the speed of film formation, it is preferable to use magnetron sputtering as the sputtering. The sputtering is not limited to magnetron sputtering, and a bipolar sputtering method using a direct-current glow discharge or a plasma generated by a high frequency, a tripolar sputtering method that adds a hot cathode, or the like may be used.

[Step S140 of Forming Antifouling Layer]

The step S140 of forming the antifouling layer is a step of forming the antifouling layer 15 on the surface of the antireflective layer 14. In the present embodiment, the step S140 of forming the antifouling layer is executed by, for example, vacuum vapor deposition.

An optical laminate 10 provided with the transparent substrate 11, the hard-coat layer 12, the adhesive layer 13, the antireflective layer 14, and the antifouling layer 15 is obtained by the above manufacturing method.

In the optical laminate 10 of the present embodiment, of the two surfaces of the transparent substrate 11, various layers may be provided as necessary on a second surface on the opposite side a first surface on which the hard-coat layer 12 and the like are stacked. For example, an adhesive-agent layer used for adhesion with another member may be provided. Another optical film may be provided via this adhesive-agent layer. As the other optical film, for example, a film functioning a polarizing film (polarizer), a phase-difference compensation film, and as a half-wave plate or quarter-wave plate can be mentioned.

On the second surface of the transparent substrate 11, a layer having a function such as reflection prevention, selective reflection, glare reduction, polarization, phase-difference compensation, viewing-angle correction or enlargement, light guiding, diffusion, brightness improvement, color phase adjustment, or electrical conduction may be directly formed.

The optical laminate 10 of the present embodiment can be applied in polarizers and other optical members and in image display devices. For example, the optical laminate 10 may be provided in the display screen of a liquid-crystal display panel, an organic EL display panel, or other image display device. This can realize an image display device that can impart high abrasion resistance to, for example, a touch-panel display unit of a smartphone or an operation device; has excellent durability; and is suitable for actual use.

The article in which the optical laminate 10 is applied is not limited to the above example of an image display device. The optical laminate 10 can be applied in various articles such as window glass and goggles; the light-receiving face of a solar battery; a smartphone screen or personal-computer display; an information input terminal; a tablet terminal; an AR (augmented reality) device; a VR (virtual reality) device; an electric display board; a glass table surface; a game machine; an operation support device for an aircraft, an electric train, or the like; a navigation system; an instrument panel; or the surface of an optical sensor.

EXAMPLES

Examples and comparative examples of the present invention are specifically described below. The examples illustrated below are merely one example, and the optical laminate and the method for manufacturing of the present invention are not limited to the following examples.

As samples of the optical laminate, samples A to E and K were prepared as the comparative examples, and samples F to J were prepared as the examples. In preparing samples A to J, resins A and B were prepared. The composition of resin A is shown in Table 1 below. The composition of resin B is shown in Table 2 below. The units of the blending ratios in Tables 1 and 2 is % by weight.

[Table 1]

[Table 1]

| Resin A | Product Name | Manufacturer | Structure | Blending Ratio |
|---|---|---|---|---|
| Acrylate | EBECRYL 8807 | Daicel-Allnex | Aliphatic urethane acrylate | 23% |
| | Viscoat#150 | Osaka Organic Chemical Industry | Tetrahydrofurfuryl acrylate | 5% |
| | ACMO | KJ Chemicals | Acryloyl morpholine | 18% |
| | UN-6060S | Negami Chemical Industrial | Polyether urethane acrylate | 30% |
| | NK Ester A9300 | Shin Nakamura Chemical Industry | Tris-(2-acryloxyethyl) isocyanurate | 14% |
| | Aronix M-111 | Toagosei | Nonylphenol EO-modified acrylate | 7% |
| Initiator | Irgacure 127 | BASF | - | 3% |

[Table 2]

[Table 2]

| Resin B | Product Name | Manufacturer | Structure | Blending Ratio |
|---|---|---|---|---|
| Acrylate | CN986 | Sartomer | Urethane acrylate oligomer | 8% |
| | SR444 | Sartomer | Pentaerythritol triacrylate | 7% |
| | SR610 | Sartomer | Polyethylene glycol (600) diacrylate | 11% |
| Silica particles | IPA-ST-L | Nissan Chemical | Silica sol of particle size of 40 to 50 nm (solid content: 30%; IPA solvent) | 37% |
| Leveling agent | BYK377 | BYK | Polyether-modified polydimethylsiloxane | 0.01% |
| Initiator | Irgacure 184 | BASF | - | 2% |

(continued)

| Resin B | Product Name | Manufacturer | Structure | Blending Ratio |
|---------|--------------|--------------|-----------|----------------|
| Solvent | PGMA | - | Propylene glycol | 30% |
| | Butyl acetate | - | Butyl acetate | 5% |

[Sample A: Comparative Example]

A TAC film (ZRD60SL made by Fujifilm) was used as the transparent substrate 11. A mixed resin containing resin A at 7.3% by weight, butyl acetate at 91.2% by weight, the leveling agent BYK-377 at 0.75% by weight, and the organic filler SSX-101 made by Sekisui Kasei at 0.75% by weight was coated onto the transparent substrate 11 by spin coating. 3,500 rpm was adopted as the spin-coating conditions. Afterward, the transparent substrate 11 coated with the mixed resin was dried for 1 minute in an 80°C environment. After this, UV irradiation was performed to set the mixed resin, and the hard-coat layer was formed on the transparent substrate 11. The metal oxide layer was formed on the hard-coat layer by using a sputtering device. Afterward, the antifouling layer was formed using a vapor deposition machine, and sample A was obtained.

In sample A that is a comparative example, it was able to be confirmed that a plurality of protruding structures of different heights is interspersed. In sample A that is a comparative example, a greater number of concave portions than convex portions was formed.

[Sample B: Comparative Example]

Sample B was obtained in the same manner as sample A other than containing resin A at 9.8% by weight, butyl acetate at 88% by weight, the leveling agent BYK-377 at 1.2% by weight, and the organic filler BMSA-18GN made by Sekisui Kasei at 1.0% by weight.

In sample B that is a comparative example, it was able to be confirmed that a plurality of protruding structures of different heights is interspersed in masses resembling floating islands. In sample B that is a comparative example, a greater number of concave portions than convex portions was formed.

[Sample C: Comparative Example]

Sample C was obtained in the same manner as sample A other than containing resin A at 11.1% by weight, butyl acetate at 86.5% by weight, the leveling agent BYK-377 at 1.3% by weight, and the organic filler BMSA-18GN made by Sekisui Kasei at 1.1% by weight.

In sample C that is a comparative example, it was able to be confirmed that a plurality of protruding structures of different heights is interspersed in masses resembling floating islands. In sample B that is a comparative example, substantially the same number of convex portions and concave portions was formed.

[Sample D: Comparative Example]

Sample D was obtained in the same manner as sample A other than making the transparent substrate 11 and the hard-coat layer be commercially available film A, which provides a cured product of an acrylic resin composition containing filler particles of a particle size centered around 2 $\mu$m on a TAC substrate of a thickness of 60 $\mu$m.

In sample D that is a comparative example, it was able to be confirmed that a plurality of protruding structures of different heights is interspersed.

[Sample E: Comparative Example]

Sample E was obtained in the same manner as sample A other than making the transparent substrate 11 and the hard-coat layer be commercially available film B, which provides a cured product of an acrylic resin composition containing filler particles of a particle size centered around 5 $\mu$m on a TAC substrate of a thickness of 60 $\mu$m.

In sample E that is a comparative example, it was able to be confirmed that a plurality of protruding structures of different heights is interspersed.

[Sample F: Example]

A TAC film (ZRD60SL made by Fujifilm) was used as the transparent substrate 11. A known method was used to coat resin B on the transparent substrate 11 to a film thickness of 10 μm. Afterward, the transparent substrate 11 coated with resin B was dried for 1 minute in an 80°C environment. After this, sample A was laminated as the transfer mold 150. UV irradiation was then performed. After setting resin B, sample A was peeled away from the transfer mold 150, and the hard-coat layer 12 was formed on the transparent substrate 11. Next, the metal oxide layer (adhesive layer 13 and antireflective layer 14) was formed on the hard-coat layer 12 by using a sputtering device. Afterward, the antifouling layer 15 was formed using a vapor deposition machine, and sample F was obtained.

In sample F that is an example, it was able to be confirmed that a plurality of convex portions 62 having substantially the same heights as each other was formed in masses resembling floating islands. It was also able to be confirmed in sample F that each of the tops 62a of the convex portions 62 has a substantially flat face. In sample F that is an example, a greater number of convex portions 62 than concave portions 64 was formed.

[Sample G]

Sample G was obtained in the same manner as sample F other than making sample B be the transfer mold 150 to be laminated.

In sample G that is an example, it was able to be confirmed that a plurality of convex portions 62 having substantially the same heights as each other was formed in masses resembling floating islands. It was also able to be confirmed in sample G that each of the tops 62a of the convex portions 62 has a substantially flat face. In sample G that is an example, a greater number of convex portions 62 than concave portions 64 was formed.

[Sample H]

Sample H was obtained in the same manner as sample F other than making sample C be the transfer mold 150 to be laminated.

In sample H that is an example, it was able to be confirmed that a plurality of convex portions 62 having substantially the same heights as each other was formed in masses resembling floating islands. It was also able to be confirmed in sample H that each of the tops 62a of the convex portions 62 has a substantially flat face. In sample H that is an example, substantially the same number of convex portions 62 and concave portions 64 was formed.

[Sample I]

Sample I was obtained in the same manner as sample F other than making sample D be the transfer mold 150 to be laminated.

In sample I that is an example, it was able to be confirmed that a plurality of convex portions 62 having substantially the same heights as each other was formed in masses resembling floating islands.

[Sample J]

Sample J was obtained in the same manner as sample F other than making sample E be the transfer mold 150 to be laminated.

In sample J that is an example, it was able to be confirmed that a plurality of convex portions 62 having substantially the same heights as each other was formed in masses resembling floating islands.

[Sample K: Comparative Example]

A TAC film (ZRD60SL made by Fujifilm) was used as the transparent substrate 11. A known method was used to coat resin B on the transparent substrate 11 to a film thickness of 10 μm. Afterward, the transparent substrate 11 coated with resin B was dried for 1 minute in an 80°C environment. After this, sample J was laminated as the transfer mold 150. UV irradiation was then performed. After setting resin B, sample J was peeled away from the transfer mold 150, and the hard-coat layer was formed on the transparent substrate 11. Next, the metal oxide layer was formed on the hard-coat layer by using a sputtering device. Afterward, the antifouling layer was formed using a vapor deposition machine, and sample K was obtained.

In sample K that is a comparative example, it was able to be confirmed that a plurality of protruding structures of different heights is interspersed.

[Shape Evaluation]

The surface shapes of samples A to K were imaged using Scanning White Interference Microscope VS1800 made by Hitachi High-Technologies. The objective lens was set to 20× for the imaging. After imaging, a csv file recording measurement data of the heights of the pixels of the captured image was acquired. Upon detecting the lowest height from the csv file, all the data was offset so the lowest point is 0 (zero). Afterward, the highest height was detected, and a histogram was prepared. On the basis of the histogram, the values for the height A of the highest point and the mode P given in formula (1) above were obtained.

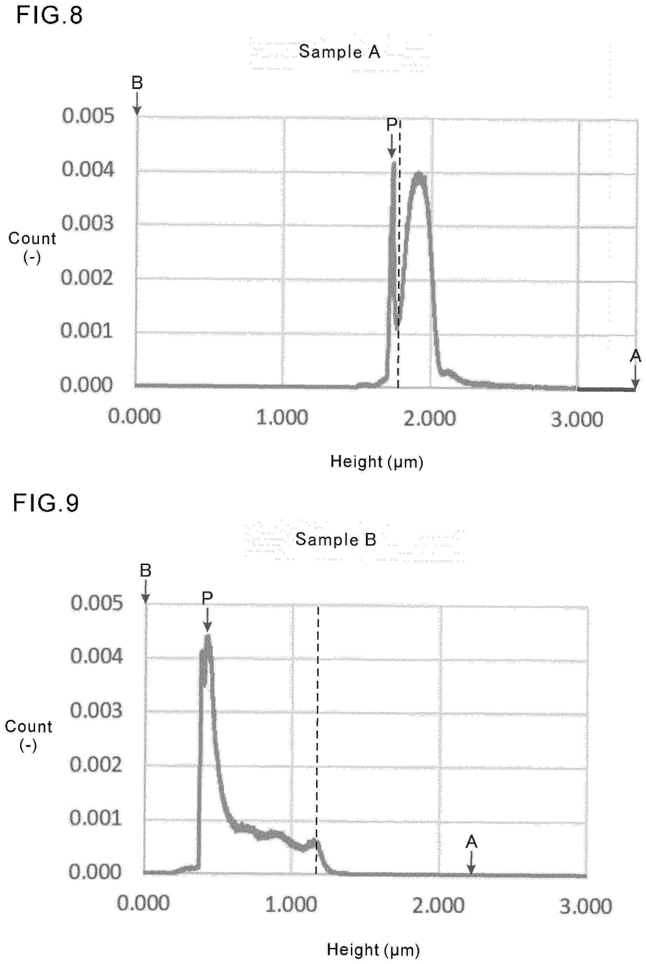

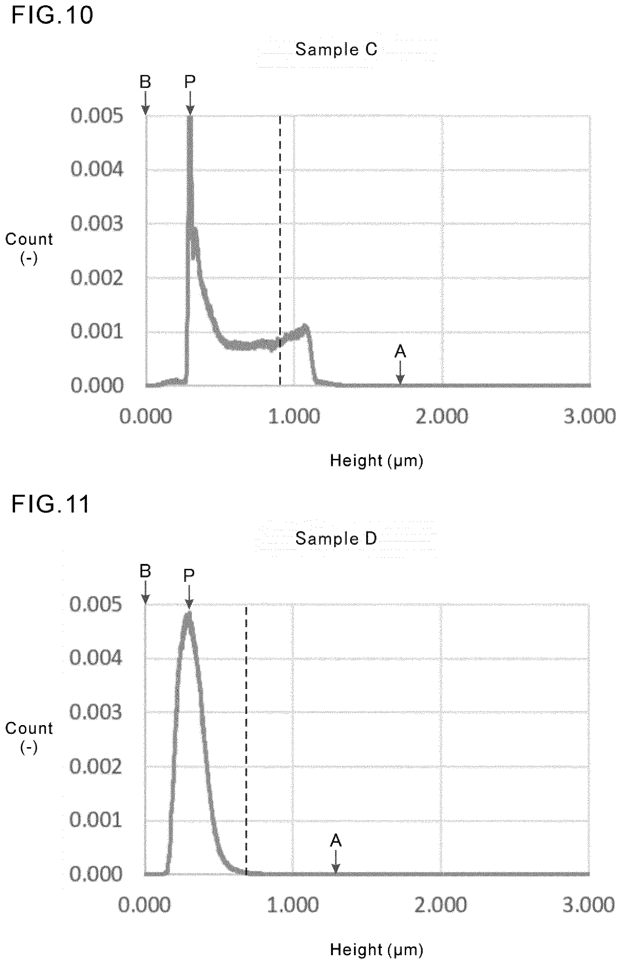

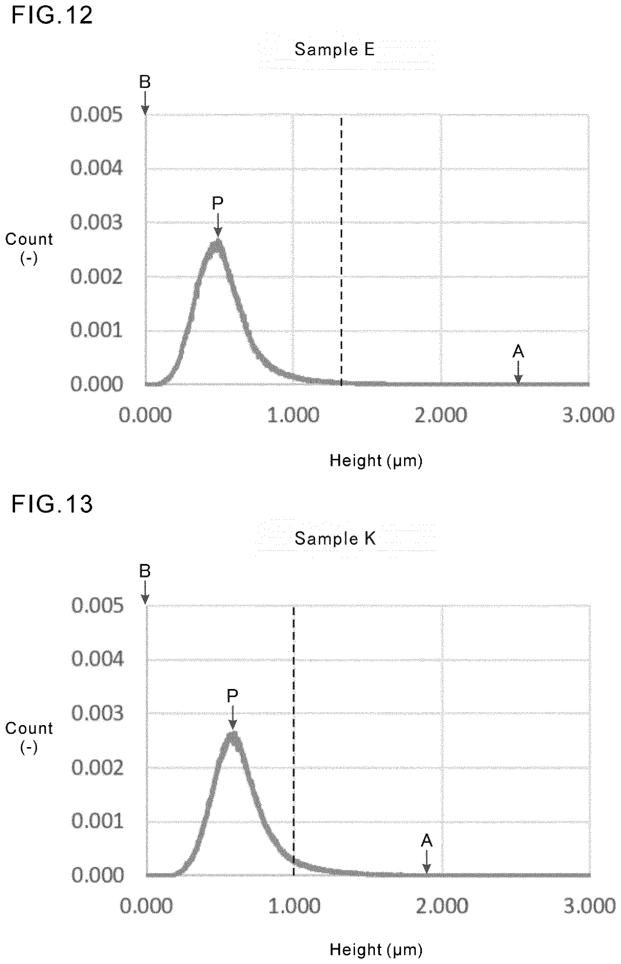

FIG. 8 is a diagram illustrating the histogram for sample A that is a comparative example. FIG. 9 is a diagram illustrating the histogram for sample B that is a comparative example. FIG. 10 is a diagram illustrating the histogram for sample C that is a comparative example. FIG. 11 is a diagram illustrating the histogram for sample D that is a comparative example. FIG. 12 is a diagram illustrating the histogram for sample E that is a comparative example. FIG. 13 is a diagram illustrating the histogram for sample K that is a comparative example. In FIGS. 8 to 13, the dashed line indicates the value "A/1.9."

As illustrated in FIG. 8, the height A of the highest point of sample A that is a comparative example was 3.41 μm, and the mode P was 1.76. Therefore, in sample A, A/1.9 > P. That is, in the histogram illustrated in FIG. 8, the mode P is positioned to the left of the dashed line indicating A/1.9.

As illustrated in FIG. 9, the height A of the highest point of sample B that is a comparative example was 2.21 μm, and the mode P was 0.43. Therefore, in sample B, A/1.9 > P. That is, in the histogram illustrated in FIG. 9, the mode P is positioned to the left of the dashed line indicating A/1.9.

As illustrated in FIG. 10, the height A of the highest point of sample C that is a comparative example was 1.71 μm, and the mode P was 0.30. Therefore, in sample C, A/1.9 > P. That is, in the histogram illustrated in FIG. 10, the mode P is positioned to the left of the dashed line indicating A/1.9.

As illustrated in FIG. 11, the height A of the highest point of sample D that is a comparative example was 1.29 μm, and the mode P was 0.30. Therefore, in sample D, A/1.9 > P. That is, in the histogram illustrated in FIG. 11, the mode P is positioned to the left of the dashed line indicating A/1.9.

As illustrated in FIG. 12, the height A of the highest point of sample E that is a comparative example was 2.51 μm, and the mode P was 0.49. Therefore, in sample E, A/1.9 > P. That is, in the histogram illustrated in FIG. 12, the mode P is positioned to the left of the dashed line indicating A/1.9.

As illustrated in FIG. 13, the height A of the highest point of sample K that is a comparative example was 1.90 μm, and the mode P was 0.59. Therefore, in sample K, A/1.9 > P. That is, in the histogram illustrated in FIG. 13, the mode P is positioned to the left of the dashed line indicating A/1.9.

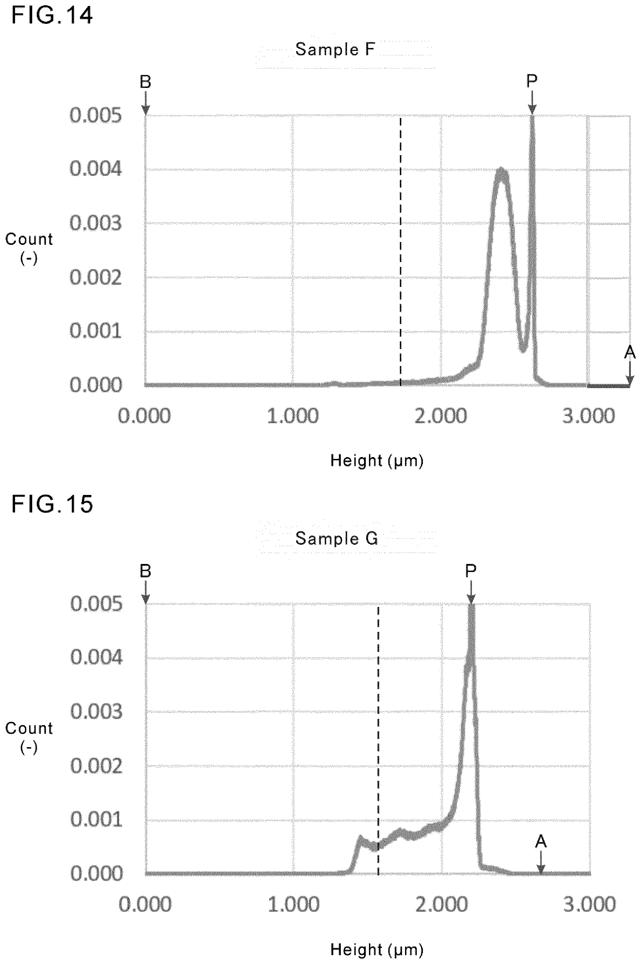

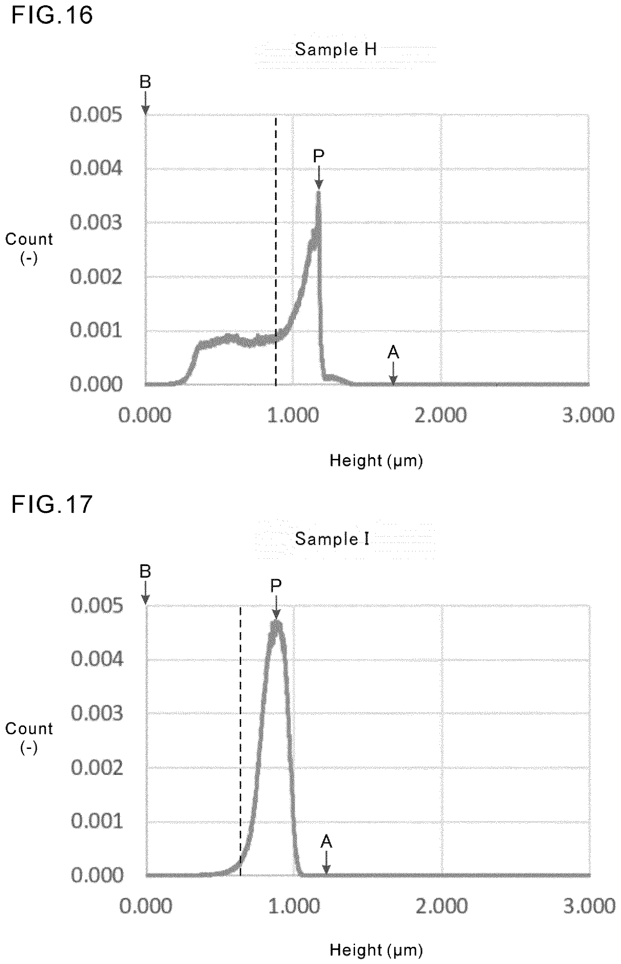

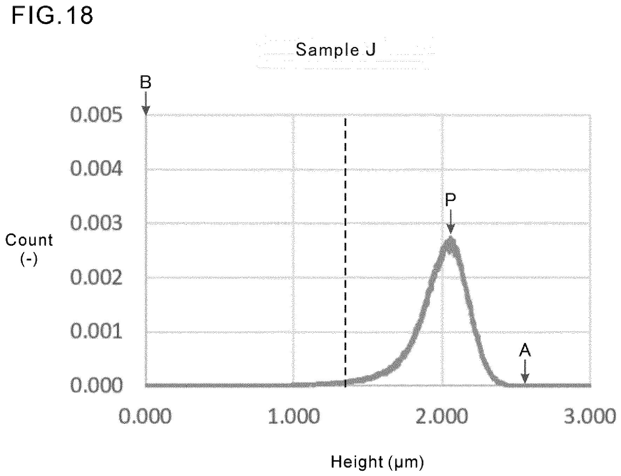

FIG. 14 is a diagram illustrating the histogram for sample F that is an example. FIG. 15 is a diagram illustrating the histogram for sample G that is an example. FIG. 16 is a diagram illustrating the histogram for sample H that is an example. FIG. 17 is a diagram illustrating the histogram for sample I that is an example. FIG. 18 is a diagram illustrating the histogram for sample J that is an example. In FIGS. 14 to 18, the dashed line indicates the value "A/1.9."

As illustrated in FIG. 14, the height A of the highest point of sample F that is an example was 3.26 μm, and the mode P was 2.62. Therefore, in sample F, A/1.9 < P. That is, in the histogram illustrated in FIG. 14, the mode P is positioned to the right of the dashed line indicating A/1.9.

As illustrated in FIG. 15, the height A of the highest point of sample G that is an example was 2.66 μm, and the mode P was 2.21. Therefore, in sample G, A/1.9 < P. That is, in the histogram illustrated in FIG. 15, the mode P is positioned to the right of the dashed line indicating A/1.9.

As illustrated in FIG. 16, the height A of the highest point of sample H that is an example was 1.67 μm, and the mode P was 1.17. Therefore, in sample H, A/1.9 < P. That is, in the histogram illustrated in FIG. 16, the mode P is positioned to the right of the dashed line indicating A/1.9.

As illustrated in FIG. 17, the height A of the highest point of sample I that is an example was 1.22 μm, and the mode P was 0.87. Therefore, in sample I, A/1.9 < P. That is, in the histogram illustrated in FIG. 17, the mode P is positioned to the right of the dashed line indicating A/1.9.

As illustrated in FIG. 18, the height A of the highest point of sample J that is an example was 2.57 μm, and the mode P was 2.08. Therefore, in sample J, A/1.9 < P. That is, in the histogram illustrated in FIG. 17, the mode P is positioned to the right of the dashed line indicating A/1.9.

From the above results, it was confirmed that samples F, G, H, I, and J that are examples satisfy the above formula (1). That is, in samples F to J that are examples, in the uneven surface 60 that is the outermost surface of the optical laminate 10 (surface of antifouling layer 15), it was confirmed that the tops 62a of the plurality of convex portions 62 had substantially the same heights as each other, each of the tops 62a of the plurality of convex portions 62 had a substantially flat face, and the uneven surface 60 has a rough surface structure with excellent abrasion resistance.

It was confirmed that samples A, B, C, D, E, and K that are comparative examples do not satisfy the above formula (1). That is, in samples A to E and K that are comparative examples, in the uneven surface that is the outermost surface of the optical laminate (toward antifouling layer), it was confirmed that the heights of each of the tops of the plurality of convex portions were not substantially the same, the uneven surface was a protruding structure including many sharp protrusions (pointed tips) of different heights from each other, and abrasion resistance was inferior.

[Evaluation of Abrasion Resistance]

Test pieces were prepared by using transparent PSA: (TD06A) made by Tomoegawa to respectively affix samples A to E and K that are comparative examples and samples F to J that are examples to 100 mm × 50 mm soda glass. Next, using a type I rubbing tester conforming to JIS L0849, the rubbing body was reciprocated horizontally along the surface of each test piece. Steel wool (#0000, made by Bonstar Co., Ltd.) was used as the rubbing body. The condition settings for this rubbing test were a load of 1 kg, a contact area of 1 cm × 1 cm, a sliding distance of 50 mm, and a sliding speed of 60 reciprocations/min. The number of horizontal reciprocation was made to be 2,000. Afterward, the pure water contact angle was measured.

The pure water contact angle (WCA) was measured by ellipse fitting under the following conditions using the fully automatic contact angle meter DM-700 (made by Kyowa Interface Science Co., Ltd.). Distilled water was placed in a glass syringe, a stainless-steel needle was attached to the tip, and pure water was added by drops to each test piece.

Amount of pure water added by drops: 2.0 μL
Measurement temperature: 25°C
The contact angle after 4 seconds elapsed from adding the pure water by drops was measured at six arbitrary locations on the surface of the test piece, and the average value thereof was used as the pure water contact angle (WCA).

[Optical Evaluation]

The external haze values of samples A to E and K that are comparative examples and samples F to J that are examples were measured. Measurement of the external haze value was performed on the basis of JIS K7136 using NDH-7000 made by Nippon Denshoku.

The results of the above measurement for samples F to J that are examples are shown together in Table 31 below. The results of the measurement for samples A to E and K that are comparative examples are shown together in Table 4 below.

[Table 3]

[Table 3]

|  | Examples | | | | |
|---|---|---|---|---|---|
|  | Sample F | Sample G | Sample H | Sample I | Sample J |
| External haze value [%] | 33.3 | 30.8 | 34.0 | 3.5 | 10.4 |
| Sa [nm] | 148 | 210 | 237 | 68 | 145 |
| Highest point A [μm] | 3.26 | 2.66 | 1.67 | 1.22 | 2.57 |
| Mode P [μm] | 2.62 | 2.21 | 1.17 | 0.87 | 2.08 |
| A/1.9 [μm] | 1.72 | 1.40 | 0.88 | 0.64 | 1.35 |
| P-(A/1.9) [μm] | 0.90 | 0.81 | 0.29 | 0.23 | 0.73 |
| A/1.9 < P | True | True | True | True | True |
| WCA [°] | 90.5 | 98.4 | 100.2 | 95.4 | 95.6 |

[Table 4]

[Table 4]

| | Comparative Examples | | | | | |
|---|---|---|---|---|---|---|
| | Sample A | Sample B | Sample C | Sample D | Sample E | Sample K |
| External haze value [%] | 34.4 | 31.8 | 35.1 | 3.6 | 10.1 | 10.4 |
| Sa [nm] | 196 | 209 | 248 | 68 | 153 | 150 |
| Highest point A [$\mu$m] | 3.41 | 2.21 | 1.71 | 1.29 | 2.51 | 1.90 |
| Mode P [$\mu$m] | 1.76 | 0.43 | 0.30 | 0.30 | 0.49 | 0.59 |
| A/1.9 [$\mu$m] | 1.79 | 1.16 | 0.90 | 0.68 | 1.32 | 1.00 |
| P-(A/1.9) [$\mu$m] | -0.03 | -0.73 | -0.60 | -0.38 | -0.83 | -0.41 |
| A/1.9 < P | False | False | False | False | False | False |
| WCA [°] | 53.2 | 51.1 | 52.3 | 52.1 | 57.6 | 55.7 |

Referring to the results in Tables 3 and 4, it is understood that the external haze values [%] of samples F to J that are examples were 3 to 40% as in samples A to E and K that are comparative examples. Therefore, it was confirmed that samples F to J that are examples have external haze values [%] equivalent to samples A to E and K that are comparative examples.

Referring to the results in Tables 3 and 4, it is understood that the surface roughnesses Sa [nm] of samples F to J that are examples were 60 to 250 nm as in samples A to E and K that are comparative examples. Therefore, it was confirmed that samples F to J that are examples have surface roughnesses Sa equivalent to samples A to E and K that are comparative examples.

From the above measurement results of the external haze value [%] and the surface roughness Sa [nm], it was understood that samples F to J that are examples have anti-glare properties equivalent to samples A to E and K that are comparative examples.

Referring to the results in Table 3, it was confirmed that samples F to J that are examples satisfy formula (1) above. That is, for samples F to J that are examples, it was confirmed that the tops 62a of the plurality of convex portions 62 constituting the uneven surface 60 that is the outermost surface (antifouling layer 15) have substantially the same heights as each other and that each of the tops 62a of the plurality of convex portions 62 has a substantially flat face.

Referring to the results in Table 4, it was confirmed that samples A to E and K that are comparative examples do not satisfy formula (1) above. That is, for examples A to E and K that are comparative examples, it was confirmed that the heights of the tops of the plurality of convex portions constituting the uneven surface that is the outermost surface (antifouling layer) are not substantially the same and that the tops are not flat faces-in other words, are provided with a protruding structure having a plurality of protrusions of different heights from each other.

Referring to the results in Table 3, for samples F to J that are examples, it was confirmed that the contact angle relative to water of the outermost surface after performing the rubbing test was 90 degrees or greater. It was thus understood that samples F to J that are examples have high abrasion resistance.

Referring to the results in Table 4, for samples A to E and K that are comparative examples, it was confirmed that the contact angle relative to water of the outermost surface after performing the rubbing test was 58 degrees or less.

That is, the contact angle relative to water of the outermost surface after performing the rubbing test for samples F to J that are examples was 1.57 to 1.96 times the contact angle of samples A to E and K that are comparative examples.

As described above, the present embodiment can provide an optical laminate 10 with significantly improved abrasion resistance than the conventional technology while having anti-glare properties equivalent to the conventional technology, which forms a concave/convex structure using filler particles of approximately 1 to 10 $\mu$m. The present embodiment can also provide a polarizer and image display device provided with this optical laminate 10.

An embodiment of the present invention is described above with reference to the included drawings. However, it is needless to say that the present invention is not limited to this embodiment. It is clear that a person skilled in the art would be able to conceive of various modifications and revisions within the scope of the claims, and it is understood that such modifications and revisions would also fall under the technical scope of the present invention.

In the above embodiment, an example is given in which the optical laminate 10 is provided with the adhesive layer 13, the antireflective layer 14, and the antifouling layer 15. However, it is sufficient for the optical laminate 10 to be provided with at least one or more metal-oxide layers made of a metal oxide on the hard-coat layer 12. The metal-oxide layer may be the various optical functional layers described above. For example, the optical laminate 10 may be provided with the transparent substrate 11, the hard-coat layer 12, the adhesive layer 13, an optical functional layer, and the antifouling layer 15. Furthermore, one or both among the adhesive layer 13 and the antifouling layer 15 do not need to be provided.

**REFERENCE SIGNS LIST**

> 10 Optical laminate
> 11 Transparent substrate
> 12 Hard-coat layer
> 13 Adhesive layer (metal-oxide layer)
> 14 Antireflective layer (metal-oxide layer)
> 14a High refractive index layer
> 14b Low refractive index layer
> 150 Transfer mold
> 30 Concave/convex structure
> 32 Convex portion
> 32a Top
> 34 Concave portion
> 60 Uneven surface
> 62 Convex portion
> 62a Top
> 64 Concave portion

**Claims**

1. An optical laminate, comprising:

   a transparent substrate;
   at least one or more hard-coat layers that are provided on the transparent substrate and are made of a resin composition; and
   at least one or more metal-oxide layers that are provided on the hard-coat layer and are made of a metal oxide; wherein
   a concave/convex structure is formed on the metal-oxide-layer-side surface of the hard-coat layer, and
   the height distribution of the surface of the concave/convex structure satisfies the following formula (1).

$$A/1.9 < P \quad (1)$$

   A: The height of the highest point on the surface of the concave/convex structure when the height B of the lowest point on the surface of the concave/convex structure is defined as 0
   P: The mode of the height distribution of the surface of the concave/convex structure when the height B of the lowest point on the surface of the concave/convex structure is defined as 0

2. The optical laminate of claim 1, wherein the tops of the plurality of convex portions constituting the concave/convex structure of the hard-coat layer have substantially the same heights as each other.

3. The optical laminate of claim 2, wherein the outermost surface of the optical laminate is made to be an uneven surface conforming to the shape of the concave/convex structure of the hard-coat layer, and
   the tops of the plurality of convex portions constituting the uneven surface have substantially the same heights as each other.

4. The optical laminate of any one among claims 1 to 3, wherein each of the tops of the plurality of convex portions constituting the concave/convex structure of the hard-coat layer has a substantially flat face.

5. The optical laminate of claim 4, wherein the outermost surface of the optical laminate is made to be an uneven surface conforming to the shape of the concave/convex structure of the hard-coat layer, and
   each of the tops of the plurality of convex portions constituting the uneven surface has a substantially flat face.

6.  The optical laminate of any one among claims 1 to 3, wherein the surface roughness Sa of the concave/convex structure of the hard-coat layer is 50 to 300 nm.

7.  The optical laminate of any one among claims 1 to 3, wherein the contact angle relative to water of the outermost surface of the optical laminate upon using a rubbing tester using steel wool to rub the steel wool against the surface of the optical laminate under conditions of a load of 1 kg, a contact area of 1 cm × 1 cm, and 2,000 reciprocations is 90 degrees or greater.

8.  The optical laminate of any one among claims 1 to 3, wherein the external haze value defined in JIS K 7136 is 3 to 40%.

9.  The optical laminate of any one among claims 1 to 3, wherein the hard-coat layer comprises metal-oxide fine particles having an average particle size of 20 to 100 nm.

10. The optical laminate of any one among claims 1 to 3, wherein the hard-coat layer comprises no filler particles having an average particle size of 1 $\mu$m or more.

11. The optical laminate of any one among claims 1 to 3, wherein the metal-oxide layer comprises an antireflective layer,

    the antireflective layer is made of a laminate in which a low refractive index layer and a high refractive index layer having a refractive index greater than that of the low refractive index layer are alternatingly laminated, and the optical laminate is an antireflective film having an anti-glare function and an antireflection function.

12. The optical laminate of claim 11, wherein the metal-oxide layer comprises an adhesive layer provided between the hard-coat layer and the antireflective layer.

13. A polarizer, comprising: the optical laminate of any one among claims 1 to 3.

14. An image display device, comprising: the optical laminate of any one among claims 1 to 3.

15. A method for manufacturing the optical laminate of any one among claims 1 to 3, the method comprising:

    a step of providing the hard-coat layer made of the resin composition on the transparent substrate;
    a step of providing the at least one or more metal-oxide layers on the hard-coat layer; and
    a step of providing an antifouling layer on the metal-oxide layer; wherein
    the step of providing the hard-coat layer has
    a step of coating the resin composition on the surface of the transparent substrate and
    a step of transferring a concave/convex shape of a transfer mold into the resin composition.

FIG.1

FIG.2

## FIG.3

## FIG.4

FIG.5

```
        ┌──────────────────┐
        │      START       │
        └──────────────────┘
                 │
                 ▼
        ┌──────────────────┐
        │  Coating Step    │──────S112  ┐
        └──────────────────┘            │
                 │                       ├── S110
                 ▼                       │
        ┌──────────────────┐            │
        │ Transferring Step│──────S114  ┘
        └──────────────────┘
                 │
                 ▼
        ┌──────────────────┐
        │  Adhesive Layer  │──────S120
        │   Forming Step   │
        └──────────────────┘
                 │
                 ▼
        ┌──────────────────┐
        │ Antireflective   │──────S130
        │ Layer Forming    │
        │      Step        │
        └──────────────────┘
                 │
                 ▼
        ┌──────────────────┐
        │ Antifouling Layer│──────S140
        │   Forming Step   │
        └──────────────────┘
                 │
                 ▼
        ┌──────────────────┐
        │       END        │
        └──────────────────┘
```

FIG.6

FIG.7

FIG.8

Sample A

FIG.9

Sample B

FIG.10

Sample C

FIG.11

Sample D

FIG.12

Sample E

FIG.13

Sample K

FIG.14

Sample F

FIG.15

Sample G

FIG.16

Sample H

FIG.17

Sample I

FIG.18

Sample J

## INTERNATIONAL SEARCH REPORT

| International application No. |
|---|
| **PCT/JP2022/021072** |

**A. CLASSIFICATION OF SUBJECT MATTER**

*G02B 5/02*(2006.01)i; *B32B 7/023*(2019.01)i; *G02B 1/115*(2015.01)i; *G02B 1/14*(2015.01)i; *G02B 1/18*(2015.01)i; *G02B 5/30*(2006.01)i; *G02F 1/1335*(2006.01)i; *G09F 9/00*(2006.01)i; *G09F 9/30*(2006.01)i; *H01L 27/32*(2006.01)i; *H01L 51/50*(2006.01)i; *H05B 33/02*(2006.01)i

FI:   G02B5/02 C; G02B1/14; G02B1/18; G02B1/115; G02B5/30; G02F1/1335 510; G09F9/30 349E; G09F9/00 313; G09F9/00 342; B32B7/023; H05B33/02; H05B33/14 A; H01L27/32

According to International Patent Classification (IPC) or to both national classification and IPC

**B. FIELDS SEARCHED**

Minimum documentation searched (classification system followed by classification symbols)

G02B5/02; B32B7/023; G02B1/115; G02B1/14; G02B1/18; G02B5/30; G02F1/1335; G09F9/00; G09F9/30; H01L27/32; H01L51/50; H05B33/02

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2003-114766 A (SUMITOMO CHEMICAL INDUSTRY CO., LTD.) 18 April 2003 (2003-04-18)<br>claims 1-3, 15, paragraphs [0001], [0034]-[0084], fig. 5 | 1-15 |
| Y | JP 2016-49699 A (DAI NIPPON PRINTING CO., LTD.) 11 April 2016 (2016-04-11)<br>paragraphs [0001], [0002]-[0007], [0011]-[0051], fig. 1-3 | 1-15 |
| Y | JP 2005-70435 A (FUJI PHOTO FILM CO., LTD.) 17 March 2005 (2005-03-17)<br>paragraphs [0093], [0111], [0112] | 9, 10 |
| Y | JP 2009-35595 A (JGC CATALYSTS & CHEMICALS LTD.) 19 February 2009 (2009-02-19)<br>paragraphs [0011]-[0013], [0062], table 1, example 1, the description of average particle size | 9, 10 |

☑ Further documents are listed in the continuation of Box C.      ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **20 July 2022** | **02 August 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
|---|
| **PCT/JP2022/021072** |

**C.    DOCUMENTS CONSIDERED TO BE RELEVANT**

| Category* | Citation of document, with indication, where appropriate, of the relevant passages | Relevant to claim No. |
|---|---|---|
| A | US 2021/0132259 A1 (WUHAN CHINA STAR OPTOELECTRONICS SEMICONDUCTOR DISPLAY TECHNOLOGY CO., LTD.) 06 May 2021 (2021-05-06)<br>fig. 1 | 1-15 |

Form PCT/ISA/210 (second sheet) (January 2015)

**INTERNATIONAL SEARCH REPORT**
Information on patent family members

International application No.

**PCT/JP2022/021072**

| Patent document cited in search report | | | Publication date (day/month/year) | Patent family member(s) | | | Publication date (day/month/year) |
|---|---|---|---|---|---|---|---|
| JP | 2003-114766 | A | 18 April 2003 | JP | 2000-276301 | A | |
| JP | 2016-49699 | A | 11 April 2016 | (Family: none) | | | |
| JP | 2005-70435 | A | 17 March 2005 | (Family: none) | | | |
| JP | 2009-35595 | A | 19 February 2009 | (Family: none) | | | |
| US | 2021/0132259 | A1 | 06 May 2021 | WO fig. 1 CN | 2021/047136 110707232 | A1 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5331919 B

- JP 4431540 B